# EUROPÄISCHE PATENTSCHRIFT

(11) **EP 3 053 887 B1**
(45) Veröffentlichungstag und Bekanntmachung des Hinweises auf die Patenterteilung: **28.04.2021**
(21) Anmeldenummer: 16160919.3
(22) Anmeldetag: 05.03.2012
(51) Int. Cl.: H01L 33/48, H01L 33/64, C03C 3/066, C03C 3/064, C03C 8/08, C03C 8/24, C03C 27/02, C03C 29/00

(54) **GEHÄUSE FÜR ELEKTRONISCHE BAUTEILE**
HOUSING FOR ELECTRONIC COMPONENTS
BOITIER POUR COMPOSANTS ELECTRONIQUE

(30) Priorität: 07.03.2011 DE 102011013276; 07.03.2011 DE 102011013278
(43) Veröffentlichungstag der Anmeldung: 10.08.2016
(62) Teilanmeldung aus: 12711757.0
(73) Patentinhaber: Schott AG, 55122 Mainz (DE)
(72) Erfinder: HETTLER, Robert, 84036 Kumhausen (DE); RINDT, Matthias, 84028 Landshut (DE)
(74) Vertreter: Blumbach · Zinngrebe Patentanwälte PartG mbB

(56) Entgegenhaltungen:
- DE-A1- 10 150 239
- GB-A- 1 408 256
- JP-A- H10 163 355
- US-A- 4 417 913
- US-A1- 2006 169 999
- US-A1- 2006 245 195

## Beschreibung

Die vorliegende Erfindung betrifft ein Gehäuse für elektronische Bauteile, wie FETs und/oder LEDs, und die Verwendung eines besonders geeigneten Glases zur Herstellung des genannten Gehäuses.

### Hintergrund der Erfindung

Als allgemeiner Standard werden heutzutage elektronische Bauteile, wie zum Beispiel sogenannte "High Power Light Emitting Diodes" (LED) oder Feldeffektransistoren (FET), in Kunststoff- und Harz- Konstruktionen, d.h. in organischen Gehäusen verkapselt. Jedoch ist ein in einem solchen Gehäuse positioniertes Bauteil nicht ausreichend hermetisch verkapselt gegenüber möglichen Einflüssen durch die Umgebung. Das kann zur Degradation von Materialien, Oberflächen und/oder elektrischen Verbindungen führen. Zudem erweist sich die thermische Stabilität des Harzes für elektronische Bauteile mit einem höheren Output, z.B. 5 W-LEDs oder ein FET als ein Beispiel eines Bauteils der Leistungselektronik, als problematisch.

Eine Technologie zur Überwindung dieser Nachteile ist in der Patentanmeldung WO 2009/132838 A1 beschrieben. Dort ist ein im Wesentlichen vollständiges anorganisches Gehäuse beschrieben. Es ist ein Gehäuse, das einen Verbund aus einem metallischen Basisteil und einem metallischen Kopfteil, das auf der Oberseite des Basisteils angeordnet ist, umfasst. Diese sind über eine Glasschicht miteinander verbunden. Auf dem Basisteil wird zum Beispiel ein opto-elektronisches Funktionselement positioniert. Das Kopfteil bildet über dem Basisteil unter anderem einen Reflektor für die von dem opto-elektronischen Funktionselement emittierte Strahlung oder zu empfangende Strahlung. Bei dem Zusammenfügen des Basisteils, der Glasschicht und des Kopfteils wird die Glasschicht insoweit erwärmt, dass das Glas eine Viskosität erreicht, bei der das Glas anhaftet und das Basisteil und das Kopfteil mittels der ersten Glasschicht einen Verbund bilden. Das dort beschriebene Gehäuse hat sich als sehr vorteilhaft erwiesen. Insbesondere die Glasverbindung ermöglicht das Herstellen einer hermetischen Verkapselung mit erhöhter Temperaturbeständigkeit. Mit der Technologie ist es möglich, kleine Gehäuse mit den genannten Vorteilen kostengünstig herzustellen.

Die Dokumente US 2006/169999 A1 US 5 177 034 A, US 4 742 432 A, US 4 417 913 A und JP H 10 163355 A zeigen Gehäuse für opto-elektronische Bauelemente sowie Verfahren zu deren Herstellung.

### Allgemeine Beschreibung der Erfindung

Vor dem vorstehend geschilderten Hintergrund liegt der vorliegenden Erfindung die Aufgabe zugrunde, ein alternatives Gehäuse für elektronische Bauelemente, insbesondere für FETs und/oder LEDs mit einer hohen Leistung, bereitzustellen.

Insbesondere soll es auch möglich sein, die hermetischen Eigenschaften und/oder die Langzeitstabilität des Gehäuses noch weiter zu verbessern.

Gelöst werden diese Aufgaben bereits durch das Gehäuse zur Aufnahme eines elektronischen Funktionselements, gemäß dem unabhängigen Patentanspruch 1, sowie dessen Verwendung gemäß dem unabhängigen Patentanspruch 15. Vorteilhafte Ausführungsformen des erfindungsgemäßen Gehäuses sind Gegenstand der Unteransprüche.

Allgemein sieht die Erfindung vor, ein Alkali-Titan-Silikat-Glas zum Aufbau des Gehäuses zu verwenden, wie dies in den unabhängigen Ansprüchen angegeben wird. Dieses ermöglicht unter anderem den Aufbau eines äußerst hermetischen Gehäuses. Diese Glasklasse und insbesondere die nachstehend angeführten Gläser wurden bisher nur zum Emaillieren verwendet. Beim Emaillieren werden sie zum Erstellen einer äußerst dünnen und harten Schutzschicht auf Metalloberflächen aufgebrannt. Zum Beispiel wird die sogenannte Emaille zum Versiegeln auf Töpfe, Backöfen, Gefriergeräte oder ähnlichem aufgebracht. Das Alkali-Titan-Silikat-Glas wird hier erstmalig zum Packaging bzw. zum Aufbau von Gehäusen in der Mikroelektronik eingesetzt.

Beim Emaillieren steht das Versiegeln, beispielsweise eines Topfes, im Vordergrund. Die strukturelle bzw. mechanische Festigkeit wird im Wesentlichen durch das zu versiegelnde Substrat bereitgestellt.

Die Erfinder haben nun erkannt, dass die erfindungsgemäß in den unabhängigen Ansprüchen angegebenen Gläser und insbesondere auch die nachstehend angeführten Gläser nicht nur zum Versiegeln sondern auch zum Verbinden von Bauteilen, insbesondere basierend auf Kupfer, geeignet sind. Dabei stellen die erfindungsgemäß in den unabhängigen Ansprüchen angegebenen Gläser und insbesondere auch die nachstehend angeführten Gläser die erforderliche strukturelle bzw. mechanische Festigkeit zum Aufbau eines Gehäuses bereit. Mit ihnen können insbesondere die erforderlichen und gegenüber dem Emaillieren größeren Schichtdicken bereitgestellt werden.

Vorzugsweise werden das erfindungsgemäße Alkali-Titan-Silikat-Glas wie in den unabhängigen Ansprüchen angegeben und insbesondere die nachstehend angeführten Gläser eingesetzt zum Verkapseln von elektrischen und/oder elektronischen und/oder opto-elektronischen Bauteilen.

Im Detail sieht die vorliegende Erfindung ein Gehäuse zur Aufnahme eines elektronischen und/oder opto-elektronischen Funktionselements, insbesondere einer LED und/oder ein FETs, vor. Das erfindungsgemäße Gehäuse ist ein Gehäuse aus
- einem Basiskörper mit einer Oberseite, die zumindest abschnittsweise einen Montagebereich für wenigstens ein elektronisches Funktionselement definiert, so dass der Basiskörper einen Kühlkörper für wenigstens ein elektronisches Funktionselement bildet, einer Unterseite und einem Mantel; und
- wenigstens einem Anschlusskörper für wenigstens ein elektronisches Funktionselement, welcher zumindest mittels einer Glasschicht mit dem Basiskörper verbunden ist, wobei
die verbindende Glasschicht durch ein Alkali-Titan-Silikat-Glas bereitgestellt ist. Basiskörper und Anschlusskörper umfassen ein Metall, vorzugsweise ein Metall mit einem thermischen Längenausdehnungskoeffizienten α zwischen 13 und 25 * 10⁻⁶ K⁻¹. Insbesondere wird Kupfer oder eine Kupferlegierung verwendet.

Weiterhin erstreckt sich die Erfindung auf die Verwendung eines in den unabhängigen Ansprüchen angegebenen Alkali-Titan-Silikat-Glases zum Aufbau eines Gehäuses zur Aufnahme eines elektronischen und/oder opto-elektronischen Funktionselements, insbesondere einer LED und/oder eines FETs.

Das wenigstens eine Funktionselement wird bzw. ist auf dem Basiskörper angeordnet. Der Basiskörper stellt zum einen das tragende Element für das Funktionselement dar. Der Basiskörper kann somit auch als Träger oder Grundkörper bezeichnet werden. Zum anderen stellt der Basiskörper den Kühlkörper für das Funktionselement dar.

Der Basiskörper kann einteilig oder segmentiert ausgebildet sein und zum Beispiel aus Lagen aufgebaut sein. Es können zudem auch Durchgangsleitungen, sogenannte thermische Vias, in dem Basiskörper eingebracht sein. Das Funktionselement ist nach dem Einbau in das Gehäuse bzw. nach dem Aufsetzen auf dem Basiskörper in einem direkten Kontakt mit dem Basiskörper. Die Oberseite des Basiskörpers beschreibt im Allgemeinen die Seite des Basiskörpers, auf welcher das Funktionselement positioniert ist.

Das Funktionselement kann zum Beispiel auf dem Basiskörper aufgeklebt und/oder aufgelötet werden. Als Lote werden vorzugsweise bleifreie Weichlote verwendet. Der Kleber ist vorzugsweise ein leitfähiger Kleber, wie ein mit Silber angereicherter Epoxidharz. Somit wird über einen direkten Kontakt auch ein Kontakt über einen Kleber, Lot oder ein Bindemittel verstanden.

Da der Basiskörper auch einen Kühlkörper für das Funktionselement darstellt, umfasst er Materialien, welche eine entsprechende Leitfähigkeit für Wärme besitzen. Vorzugsweise hat der Basiskörper eine Wärmeleitfähigkeit von zumindest etwa 50 W/mK, vorzugsweise von zumindest etwa 150 W/mK.

Der Basiskörper ist thermisch anschließbar an weitere Bauteile. Vorzugsweise umfasst der Basiskörper und/oder ein Kopfteil wenigstens ein Metall oder besteht aus einem Metall oder einer Legierung. Insbesondere ist das Metall oder die Legierung zumindest ein Mitglied, das ausgewählt ist aus einer Gruppe bestehend aus Kupfer, Aluminium, austenitischer Stahl und austenitischer Edelstahl.

Im Allgemeinen hat der Basiskörper in einer Aufsicht auf seine Oberseite eine Fläche von etwa 9 mm² bis etwa 1000 mm², vorzugsweise bis etwa 400 mm² oder 50 mm². Seine Höhe liegt im Allgemeinen bei etwa 0,1 mm bis etwa 10 mm, vorzugsweise bis etwa 2 mm.

Für weitere mögliche Ausgestaltungen des Basiskörpers wird Bezug genommen auf das in dem Dokument WO 2009/132838 A1 beschriebene Basisteil.

Der wenigstens eine Anschlusskörper ist ein Anschlusskörper zum Bereitstellen eines elektrischen Anschlusses für das auf der Oberseite des Basiskörpers positionierte Funktionselement. Über den Anschlusskörper kann im Allgemeinen eine Verbindung der Oberseite des Basiskörpers und somit des Funktionselements mit der Umgebung hergestellt werden.

Der wenigstens eine Anschlusskörper ist ein massiver Körper. Insbesondere wird dieser als eine metallische Platte und/oder als ein metallischer Kontaktstift bereitgestellt. Vorzugsweise kann dieser auch unter leichtem Druck, beispielsweise durch ein Pressen mit den Fingern, verformbar sein. Dieser stellt keine auf dem Basiskörper, zum Beispiel mittels eines PVD-Verfahrens, aufgebrachte oder aufgewachsene Schicht dar.

Der Anschlusskörper umfasst oder ist ein Metall oder eine Legierung. Das Metall oder die Legierung ist zumindest ein Mitglied, das ausgewählt ist aus einer Gruppe bestehend aus Kupfer, Aluminium, austenitischer Stahl und austenitischer Edelstahl.

Ist der Anschlusskörper als eine Platte ausgeführt, so hat der Anschlusskörper in einer Aufsicht auf seine Oberseite Im Allgemeinen eine Fläche von etwa 9 mm² bis etwa 1000 mm², vorzugsweise bis etwa 400 mm² oder 50 mm². Seine Höhe liegt im Allgemeinen bei etwa 0,1 mm bis etwa 5 mm, vorzugsweise bis etwa 2 mm.

Für weitere mögliche Ausgestaltungen des Anschlusskörpers als metallische Platte wird Bezug genommen auf das in dem Dokument WO 2009/132838 A1 beschriebene Kopfteil und/oder Kopfteil.

Ein Kontaktstift ist ein längliches, metallisches Bauteil mit einem im Verhältnis zu seiner Länge sehr reduzierten Querschnitt. Es ist ein nadel- oder nagelartiges Bauteil. Dieses kann nur einen geraden Schenkel besitzen oder aber auch wenigstens einen gebogenen Abschnitt aufweisen. Somit kann der Kontaktstift in einer Ausgestaltung, insbesondere zumindest abschnittsweise, als ein im Wesentlichen gerader Stift oder I-förmig bereitgestellt werden. Er kann aber in einer weiteren Ausführungsform, insbesondere zumindest abschnittsweise, als Haken oder L-förmig bereitgestellt sein. Unter einem Kontaktstift wird auch ein metallischer Draht verstanden.

Ist der Anschlusskörper als ein Kontaktstift ausgeführt, so liegt der Durchmesser des Anschlusskörpers im Allgemeinen bei etwa 0,1 mm² bis etwa 16 mm², bevorzugt bis etwa 3 mm², besonders bevorzugt bis etwa 0,8 mm².

Der Anschlusskörper ist von dem Basiskörper elektrisch isoliert. Er ist zumindest abschnittsweise durch die Glasschicht getrennt und/oder zumindest abschnittsweise beabstandet von dem Basiskörper angeordnet.

Das Glas ist ein Glas zum Verbinden des Basiskörpers mit dem Anschlusskörper und zum Isolieren des Basiskörpers von dem Anschlusskörper.

Das Glas besitzt eine Erweichungstemperatur in einem Bereich, welcher unterhalb der Schmelztemperatur der Materialien liegt, die für den Basiskörper und/oder den Anschlusskörper verwendet werden. Das Glas wird für das Verbinden oder ist beim Verbinden insoweit erwärmt, dass es eine Viskosität besitzt, bei der die Bauteile aneinander haften. Vorzugsweise besitzt das Glas beim Verbinden eine Viskosität in einem Bereich von 10⁷ Pas bis etwa 10³ Pas. Die Erwärmung erfolgt zum Beispiel in einem Ofen.

Das verwendete Glas ist ein Alkali-Titan-Silikat-Glas. Das Alkali-Titan-Silikat-Glas ist dem Material des Basiskörpers und/oder des Anschlusskörpers entsprechend gewählt. Das Alkali-Titan-Silikat-Glas ist vor allem geeignet für eine Ausführungsform, in welcher der Basiskörper und/oder der Anschlusskörper im Wesentlichen durch Kupfer und/oder Aluminium, insbesondere an der Grenzfläche bzw. den Grenzflächen zu dem Glas, bereitgestellt werden. Der Basiskörper und/oder der Anschlusskörper und/oder zumindest die jeweilige Grenzfläche besitzt bzw. besitzen einen Anteil an Kupfer oder Aluminium von mindestens 50 Gew.%, vorzugsweise von mindestens 80 Gew.%.

In einer Ausführungsform besitzt oder umfasst das Glas die folgende Zusammensetzung (in Gewichtsprozent):

| | |
|---|---|
| SiO₂ | 20-50 |
| TiO₂ | 10-35 |
| R₂0 | 10-40 |
| | |
| | |
| | |
| Al₂O₃ | 0-5 |
| CaO+SrO | 0-5 |
| P₂O₅ | 0-5 |
| V₂O₅ | 0-5 |
| B₂O₃ | 0-5 |
| | |
| Sb₂O₃ | 0-1 |
| SnO₂ | 0-5 |
| Fe₂O₃ | < 1 |
| CoO | < 1 |
| NiO | < 1 |
| | |
| | |
| | |
| ZnO | 0-4 |
| ZrO₂ | 0-4 |
| F | 0-2 |
| MoO₃ | 0-1 |
| N₂O₅ | 0-6 |
| | |
| SO₃ | 0-1 |

Die in der Tabelle verwendete Bezeichnung R₂0 stellt die Summe aller Alkali-Oxide dar. Dabei sind die Alkalimetalle wenigstens bereitgestellt durch die Elemente Li, Na und K.

In einer konkreten Ausführungsform umfasst die Gruppe R₂0 die folgenden Bestandteile (in Gewichtsprozent):

| | |
|---|---|
| Na₂O | 11 - 22 |
| K₂O | 8 - 17 |
| Li₂O | 0,2 - 3 |

In einer ersten bevorzugten Ausführungsform besitzt oder umfasst das Glas die folgende Zusammensetzung:

| | |
|---|---|
| SiO₂ | 26 - 30 |
| TiO₂ | 21 - 25 |
| Na₂O | 14 - 18 |
| K₂O | 11 - 15 |
| Li₂O | > 0 - 3 |
| Al₂O₃ | > 1 - 5 |
| CaO | > 0 - 1 |
| SrO | 0 - 1 |
| | |
| P₂O₅ | > 0 - 3 |
| | |
| B₂O₃ | > 0 - 4 |
| | |
| | |
| | |
| Fe₂O₃ | > 0 - 2 |
| CoO | 0 - 1 |
| NiO | 0 - 1 |
| | |
| | |
| | |
| ZnO | > 0 - 2 |
| ZrO₂ | > 0,5 -2 |

Vorzugsweise besitzt oder umfasst das Glas der ersten Ausführungsform die folgende Zusammensetzung:

| | |
|---|---|
| SiO₂ | 28 |
| TiO₂ | 23 |
| | |
| Na₂O | 16 |
| K₂O | 13 |
| Li₂O | 1,12 |
| Al₂O₃ | 3,4 |
| CaO | 0, 2 |
| SrO | 0,02 |
| | |
| P₂O₅ | 1, 6 |
| | |
| B₂O₃ | 2 |
| Fe₂O₃ | 0, 2 |
| CoO | 0,03 |
| NiO | <0,02 |
| | |
| | |
| | |
| ZnO | 0, 2 |
| ZrO₂ | 0, 9 |

In einer zweiten bevorzugten Ausführungsform besitzt oder umfasst das Glas die folgende Zusammensetzung:

| | |
|---|---|
| SiO₂ | 36 - 40 |
| TiO₂ | 24 - 28 |
| | |
| Na₂O | 15 - 19 |
| K₂O | 10 - 14 |
| Li₂O | > 0 - 3 |
| Al₂O₃ | 1 - 6 |
| CaO | > 0 - 1 |
| SrO | < 1 |
| | |
| P₂O₅ | > 0 - 4 |
| | |
| B₂O₃ | > 0 - 2 |
| | |
| | |
| | |
| Fe₂O₃ | 0 - 2 |
| CoO | < 1 |
| NiO | < 1 |
| | |
| | |
| | |
| ZnO | < 1 |
| ZrO₂ | < 1 |

Vorzugsweise besitzt oder umfasst das Glas der zweiten Ausführungsform die folgende Zusammensetzung:

| | |
|---|---|
| SiO₂ | 38 |
| TiO₂ | 26 |
| | |
| Na₂O | 17 |
| K₂O | 11, 6 |
| Li₂O | 1,22 |
| Al₂O₃ | 3,7 |
| CaO | 0, 3 |
| | |
| | |
| P₂O₅ | 1, 6 |
| | |
| B₂O₃ | 0,29 |
| | |
| | |
| | |
| Fe₂O₃ | 0, 08 |
| CoO | |
| NiO | <0, 02 |
| | |
| | |
| | |
| ZnO | 0 |
| ZrO₂ | 0, 1 |

Die mit dem Glas gebildete Glasschicht oder im Detail die zwischen dem Basiskörper und dem Anschlusskörper gebildete Glasschicht besitzt im Allgemeinen eine Dicke von größer als etwa 30 µm. Dadurch kann ein gasdichter Verbund mit ausreichend hohen elektrisch isolierenden Eigenschaften bereitgestellt werden. Der elektrische Widerstand der Glasschicht liegt im Allgemeinen bei größer als 1 GΩ. Die erzielte Gasdichtheit ist im Allgemeinen kleiner als 1*10⁻⁸ mbar*1/s. Die Dicke der Glasschicht ist abhängig von der Ausführungsform des Gehäuses. Vorzugsweise beträgt die Dicke der Glasschicht etwa 30 µm bis etwa 2000 µm, insbesondere bis etwa 1000 µm.

Weiterhin zeichnet sich das erfindungsgemäße Glas durch eine verbesserte Festigkeit und eine verbesserte chemische Beständigkeit aus. Zum Beispiel kann die Scherfestigkeit bei einem Probekörper (4 mm x 4 mm Verglasungsfläche und 100 µm nominelle Dicke der Glasschicht) mit dem erfindungsgemäßen Glas von durchschnittlich 60 N auf 105 N erhöht werden gegenüber dem Glas P8061. Zudem weist das erfindungsgemäße Glas gegenüber dem Glas G018-122 (siehe dazu die WO 2009/132838 A1) eine verbesserte chemische Beständigkeit auf. Die Galvanik kann nach dem Verglasen durchgeführt werden.

Im Allgemeinen kann das Glas durch zumindest ein Verfahren aufgebracht werden, welches ausgewählt ist aus einer Gruppe bestehend aus Siebdrucken, Dispensen, Bereitstellen eines vorzugsweise gestanztes Glasbandes und/oder Bereitstellen eines individuellen Vorformlings. Ein Glasband kann zum Beispiel durch in die Form eines Bandes gegossenes Schlicker bereitgestellt werden.

Ein Verfahren zur Herstellung eines elektronischen Funktionselementgehäuses wird wie folgt offenbart. Es umfasst die folgenden Verfahrensschritte:
- Bereitstellen wenigstens eines Basiskörpers mit einer Oberseite, welche zumindest abschnittsweise einen Montagebereich für wenigstens ein elektronisches Funktionselement definiert, so dass der Basiskörper einen Kühlkörper für wenigstens ein elektronische Funktionselement bildet,
- Bereitstellen wenigstens eines Anschlusskörpers für wenigstens ein elektronisches Funktionselement und zumindest eines Glases, insbesondere zwischen dem Basiskörper und dem Anschlusskörper, zum Verbinden des zumindest einen Anschlusskörpers mit dem Basiskörper,
- Erwärmen des Glases insoweit, dass dieses eine Viskosität besitzt und/oder erreicht, bei der es anhaftet und aus dem Basiskörper und dem Anschlusskörper ein Verbund bildbar ist,
- Abkühlen des Glases, so der Basiskörper und der wenigstens eine Anschlusskörper einen stoffschlüssigen Verbund bilden.

Das erwärmte Glas befindet sich beim Zusammenfügen in einem Temperaturbereich von 400°C bis 1000°C, vorzugsweise von 500°C bis 700°C.

Für weitere mögliche Ausgestaltungen der Glasschicht und der Verfahren zum Verwenden einer Glasschicht für die Herstellung eines erfindungsgemäßen Gehäuses wird Bezug genommen auf die in dem Dokument WO 2009/132838 A1 beschriebene erste und/oder zweite Glasschicht.

Um ein verbessertes Anhaften des Anschlusskörpers an dem Basiskörper zu bewirken, erfolgt vorzugsweise eine Vorbehandlung der Glaskontaktflächen des Basiskörpers und/oder des Anschlusskörpers. Die genannte Vorbehandlung kann in einer Ausführungsform durch ein Voroxidieren der Glaskontaktflächen erfolgen. Unter dem Voroxidieren wird ein gezieltes Oxidieren einer Oberfläche, zum Beispiel in einer sauerstoffhaltigen Atmosphäre, verstanden. Dabei hat sich ein Verbund aus Glas und Kupfer oder Kupferoxid als sehr stabil erwiesen. Das Metall, vorzugsweise Kupfer, wird in einer sauerstoffhaltigen Atmosphäre gezielt oxidiert. Dabei hat sich für das Oxidgewicht ein Flächengewicht von etwa 0,02 bis etwa 0,25 mg/cm², vorzugsweise von etwa 0,067 bis etwa 0,13 mg/cm², Oxidgewicht als vorteilhaft erwiesen. Das Oxid haftet gut und blättert nicht ab. Dies ist insbesondere zutreffend, wenn das Kupfer mit einem Anteil von größer als 50 Gew.%, vorzugsweise von größer als 80 Gew.%, in dem Basiskörper und/oder in dem Anschlusskörper und/oder in den Grenzflächen bereitgestellt wird. Das erfindungsgemäße Glas ist insbesondere dehnungskompatibel mit Kupfer.

Zum Verbessern der Eigenschaften des Basiskörpers und/oder des Anschlusskörpers, beispielsweise der Reflektivität, der Bondbarkeit und/oder der elektrischen Leitfähigkeit, können diese, vorzugsweise zumindest abschnittsweise, beschichtet und/oder verkleidet sein, vorzugsweise mit einem Metall. Das Material, vorzugsweise das Metall, zur Herstellung der Beschichtung und/oder der Verkleidung ist wenigstens ein Material, das ausgewählt ist aus einer Gruppe bestehend aus Silber, Aluminium, Nickel, Palladium und Gold. Das Verfahren zum Erzeugen oder Herstellen der Beschichtung ist wenigstens ein Verfahren, das ausgewählt ist aus einer Gruppe bestehend aus Galvanisieren und Verdampfen, insbesondere PVD und/oder CVD.

In einer ersten Ausführungsform ist die Glasschicht oder das Glas zumindest abschnittsweise auf der Oberseite und/oder der Unterseite des Basiskörpers angeordnet. Die Glasschicht ist vorzugsweise zumindest abschnittsweise zwischen der Oberseite des Basiskörpers und der Unterseite des wenigstens einen Anschlusskörpers angeordnet. In einer Variante erstreckt sich der wenigstens eine Anschlusskörper zumindest abschnittsweise über den Basiskörper. Er stellt wenigstens eine Lasche zum Verbinden bereit.

In einer Weiterbildung des Gehäuses ist auf der Oberseite des Basiskörpers und auf der Oberseite des wenigstens einen Anschlusskörpers noch ein Kopfteil positioniert. Für mögliche Ausgestaltungen des Kopfteils wird Bezug genommen auf das in dem Dokument WO 2009/132838 A1 beschriebene Kopfteil.

In einer zweiten Ausführungsform ist die Glasschicht oder das Glas zumindest abschnittsweise zwischen dem Mantel des Basiskörpers und dem Anschlusskörper angeordnet. Dazu ist der wenigstens eine Anschlusskörper mantelseitig an dem Basiskörper angeordnet. Der Anschlusskörper erstreckt sich zumindest abschnittsweise über den Umfang des Basiskörpers.

In einer weiteren Ausgestaltung des Gehäuses wird zumindest auf seiner Unterseite eine Isolation aufgebracht. Dazu ist auf der Unterseite des Basiskörpers und gegebenenfalls auf der Unterseite des Anschlusskörpers eine Isolation, welche vorzugsweise durch eine isolierende Schicht bereitgestellt wird, vorgesehen. Die Isolation kann durchgehend oder auch segmentiert sein. Das Material für die Isolation ist oder umfasst vorzugsweise ein Glas und/oder eine Keramik. Die Schicht kann zum Beispiel über ein Emaillieren und/oder ein Cold-Spray-Verfahren aufgebracht werden. Dadurch kann die Unterseite des Gehäuses potentialfrei bereitgestellt werden.

In einer weiteren Ausgestaltung des Gehäuses ist eine Hülse mantelseitig an dem Basiskörper angeordnet. Die Hülse oder Hülle erstreckt sich zumindest abschnittsweise über den Umfang des Basiskörpers und/oder des Anschlusskörpers. Die Hülse ist über die oder eine Glasschicht an dem Basiskörper und/oder an dem Anschlusskörper befestigt. Die Glasschicht befindet sich zwischen dem Basiskörper und der Hülse. Die Hülse wird vorzugsweise als eine metallische Hülse, zum Beispiel aus Edelstahl, bereitgestellt. Dadurch ist es möglich, zumindest die Außenseite des Gehäuses mit einem definierten Potential, beispielsweise mit dem Erdpotential, bereitzustellen.

Weiterhin erstreckt sich die Erfindung auf ein elektronisches und/oder opto-elektronisches Bauteil, welches ein erfindungsgemäßes Gehäuse und wenigstens ein strahlungsemittierendes und/oder strahlungsempfangendes opto-elektronisches Funktionselement, insbesondere eine LED, und/oder wenigstens ein Bauelement der Leistungselektronik, insbesondere ein FET, das in dem Gehäuse angeordnet ist, umfasst.

Das Gehäuse und/oder das elektronische Bauteil und/oder das das opto-elektronische Bauteil ist bzw. sind insbesondere geeignet für eine Anwendung in einer rauen Umgebung ("harsh environment"), wie zum Beispiel unter Feuchtigkeitseinfluss und/oder aggressiven Gaseinfluss und/oder Strahlungseinfluss.

Ferner liegt im Rahmen der vorliegenden Erfindung auch eine Beleuchtungseinrichtung, zum Beispiel eine Innenbeleuchtung und/oder eine Außenbeleuchtung, welche wenigstens ein Gehäuse und/oder ein opto-elektronisches Bauteil gemäß der vorliegenden Erfindung beinhaltet, insbesondere zum Einsatz in einem Fahrzeugen und/oder einem Flugzeug und/oder als Flugfeldbeleuchtung. Beispiele für die Beleuchtungseinrichtung sind eine Sitzbeleuchtung; ein Leselicht; eine Arbeitsleuchte, die insbesondere in Decken oder Wänden integrierbar ist; eine Objektbeleuchtung in Möbeln und/oder Gebäuden; ein Scheinwerfer und/oder ein Rücklicht und/oder eine Innenbeleuchtung und/oder eine Instrumenten- oder Display-Beleuchtung, vorzugsweise in Kraftfahrzeugen und/oder Flugzeugen; eine Hintergrundbeleuchtung für LCD-Displays; eine UV-Beleuchtung, vorzugsweise in der Medizin und/oder zur Wasserreinigung; und/oder eine Beleuchtung für eine raue Umgebung ("harsh environment"), wie zum Beispiel unter Feuchtigkeitseinfluss, aggressivem Gaseinfluss und/oder Strahlungseinfluss.

Allgemein ist vorgesehen, das im Stand der Technik beschriebene und wenigstens aus zwei Lagen aufgebaute Gehäuse auf ein Gehäuse zu reduzieren, das nur noch aus einer einzelnen Lage aufgebaut ist. Es ist ein 1-Lagen-Gehäuse. Allgemein ist das Gehäuse aufgebaut aus einem Basiskörper und wenigstens einem in und/oder an dem Basiskörper angebrachten Anschlusskörper. Vorzugsweise ist das Gehäuse ein im Wesentlichen anorganisches Gehäuse. Es besteht aus oder umfasst den metallischen Basiskörper, das Glas und wenigstens einen metallischen Anschlusskörper. Es sind im Allgemeinen keine weiteren Komponenten auf der Oberseite des Gehäuses, hier bereitgestellt durch den Basiskörper, aufgebracht. Jedoch kann das erfindungsgemäße Gehäuse nach einem Einbau bzw. einem Aufsetzen eines opto-elektronischen Funktionselements gegebenenfalls an seiner Oberseite mit einem optischen Bauelement abgeschlossen werden.

Im Detail ist ein Gehäuse zur Aufnahme eines opto-elektronischen Funktionselements, insbesondere einer LED, vorgesehen, welches zumindest aus den folgenden Bestandteilen aufgebaut ist oder aus den folgenden Bestandteilen besteht. Das Gehäuse ist ein Gehäuse aus
- einem Basiskörper mit einer Oberseite, die zumindest abschnittsweise einen Montagebereich für wenigstens ein opto-elektronisches Funktionselement definiert, so dass der Basiskörper einen Kühlkörper für wenigstens ein opto-elektronisches Funktionselement bildet, einer Unterseite und einem Rand; und
- wenigstens einem Anschlusskörper für wenigstens ein opto-elektronisches Funktionselement, welcher mit dem Basiskörper, insbesondere stoffschlüssig, verbunden ist, wobei
- der Basiskörper wenigstens einen Kanal aufweist, in welchem der wenigstens eine Anschlusskörper zumindest abschnittsweise angeordnet ist und welcher zumindest abschnittsweise mit einem Glas zum Verbinden des Basiskörpers mit dem Anschlusskörper befüllt ist.

Weiterhin erstreckt sich ein nicht erfindungswesentliches Verfahren zur Herstellung eines opto-elektronischen Funktionselementgehäuses, insbesondere für eine LED, umfassend die folgenden Verfahrensschritte:
- Bereitstellen wenigstens eines Basiskörpers mit wenigstens einem Kanal und mit einer Oberseite, welche zumindest abschnittsweise einen Montagebereich für wenigstens ein opto-elektronisches Funktionselement definiert, so dass der Basiskörper einen Kühlkörper für wenigstens ein opto-elektronisches Funktionselement bildet,
- Bereitstellen wenigstens eines Anschlusskörpers für wenigstens ein opto-elektronisches Funktionselement und zumindest eines Glases zum Verbinden des zumindest einen Anschlusskörpers mit dem Basiskörper in dem wenigstens einen Kanal,
- Erwärmen des Glases insoweit, dass dieses in dem wenigstens einen Kanal eine Viskosität besitzt und/oder erreicht, bei der es anhaftet und aus dem Basiskörper und dem Anschlusskörper ein Verbund bildbar ist,
- Abkühlen des Glases, so der Basiskörper und der wenigstens eine Anschlusskörper einen stoffschlüssigen Verbund bilden, wobei der wenigstens eine Anschlusskörper zumindest abschnittsweise in dem Glas eingebettet ist.

In einer bevorzugten Ausgestaltung des Verfahrens werden der Basiskörper und/oder der Anschlusskörper und/oder das Glas jeweils in einer Matrix bereitgestellt.

Das wenigstens eine Funktionselement wird bzw. ist auf dem Basiskörper angeordnet. Der Basiskörper stellt zum einen das tragende Element für das Funktionselement dar. Der Basiskörper kann somit auch als Träger oder Grundkörper bezeichnet werden. Zum anderen stellt der Basiskörper den Kühlkörper für das Funktionselement dar.

Der Basiskörper kann hierbei einteilig oder segmentiert ausgebildet und zum Beispiel aus Lagen aufgebaut sein. Es können zudem auch Durchgangsleitungen, sogenannte thermische Vias, in dem Basiskörper eingebracht sein. Das Funktionselement ist nach dem Einbau in das Gehäuse bzw. nach dem Aufsetzen auf dem Basiskörper in direktem Kontakt mit dem Basiskörper.

Das Funktionselement kann zum Beispiel auf dem Basiskörper aufgeklebt und/oder aufgelötet werden. Als Lote werden vorzugsweise bleifreie Weichlote verwendet. Der Kleber ist vorzugsweise ein leitfähiger Kleber, wie ein mit Silber angereicherter Epoxidharz. Somit wird über einen direkten Kontakt auch ein Kontakt über einen Kleber, Lot oder ein Bindemittel verstanden.

Da der Basiskörper auch einen Kühlkörper für das Funktionselement darstellt, umfasst dieser Materialien, welche eine entsprechende Leitfähigkeit für Wärme besitzen. Vorzugsweise besitzt der Basiskörper eine Wärmeleitfähigkeit von zumindest etwa 50 W/mK, vorzugsweise von zumindest etwa 150 W/mK.

Der Basiskörper ist thermisch anschließbar an weitere Bauteile. Vorzugsweise umfasst der Basiskörper wenigstens ein Metall oder besteht aus einem Metall oder einer Legierung. Ein gängiges Metall ist zum Beispiel Kupfer und/oder Aluminium und/oder Nickel und/oder Eisen und/oder Molybdän und/oder Kupfer-Wolfram und/oder Cu-Molybdän.

Für weitere mögliche Ausgestaltungen des Basiskörpers wird Bezug genommen auf das in dem Dokument WO 2009/132838 A1 beschriebene Basisteil.

Der Montagebereich für wenigstens ein Funktionselement kann sich im Zentrum oder im Bereich der Mittelachse oder auf der Mittelachse des Basiskörpers befinden.

Im Allgemeinen besitzt der Basiskörper in einer Aufsicht auf seine Oberseite eine Fläche von etwa 5 mm² bis etwa 1000 mm², vorzugsweise bis etwa 250 mm². Die Höhe des Basiskörpers liegt im Allgemeinen bei etwa 0,2 mm bis etwa 10 mm, vorzugsweise bis etwa 2 mm.

Der Kanal ist ein Kanal zum Führen, Aufnehmen und/oder Lagern des wenigstens einen Anschlusskörpers. In dem Kanal kann zumindest abschnittsweise oder vollständig genau ein Anschlusskörper oder eine Vielzahl von Anschlusskörpern angeordnet sein. Es kann genau ein Kanal im Basiskörper oder auch eine Vielzahl von Kanälen im Basiskörper vorgesehen sein.

Vorzugsweise ist der wenigstens eine Kanal randseitig an dem Basiskörper angeordnet und/oder nicht randseitig, d.h. im Inneren des Basiskörpers angeordnet. In einer konkreten Ausgestaltung ist der wenigstens eine Kanal als eine randseitige Aussparung an dem Basiskörper und/oder als eine nicht randseitige Aussparung im Basiskörper ausgebildet. Im Fall des nicht randseitigen Kanals ist der Kanal als eine vorderseitige und/oder eine rückseitige Aussparung in dem Basiskörper ausgeführt.

In einer Ausführungsform mündet der wenigstens eine Kanal in die Oberseite und/oder in die Unterseite und/oder in den Rand des Basiskörpers. Es wird dadurch eine, vorzugsweise durchgehende, Verbindung zwischen der Oberseite und/oder der Unterseite und/oder dem Rand des Basiskörpers erzeugt. In einer Ausführungsform erstreckt sich der Kanal von der Vorderseite in Richtung der Rückseite und/oder verbindet die Vorderseite des Basiskörpers mit seiner Rückseite und ist vorzugsweise als ein Loch ausgebildet.

In einer Ausgestaltung der Erfindung umfasst der wenigstens eine Kanal einen, vorzugsweise im Wesentlichen geraden, ersten Abschnitt. Vorzugsweise verläuft der erste Abschnitt im Wesentlichen entlang, vorzugsweise parallel zu, der Mittelachse des Basiskörpers. Wird hierbei der Kanal, vorzugsweise ausschließlich, durch einen ersten geraden Abschnitt gebildet, so ist der Kanal im Wesentlichen I-förmig.

Der erste Abschnitt des Kanals ist dabei vorzugsweise eine Öffnung oder ein Loch im Basiskörper. In der Ausgestaltung als im Wesentlichen I-förmiger Kanal ist der Kanal für die Position im nicht randseitigen Bereich des Basiskörpers rohrförmig. Er ist eine Art Rohr mit offenen Enden. Für eine Position im randseitigen Bereich stellt der Kanal dagegen eine Art Nut oder Rinne dar. Es ist sozusagen ein seitlich zum Rand hin offener Kanal.

In einer weiteren Ausführungsform umfasst der wenigstens eine Kanal, insbesondere zusätzlich, einen, vorzugsweise im Wesentlichen geraden, zweiten Abschnitt. Dieser verläuft im Wesentlichen quer, vorzugsweise senkrecht, zu dem ersten Abschnitt des Kanals.

Der zweite Abschnitt des Kanals wird vorzugsweise als eine Aussparung in der Oberseite des Basiskörpers und/oder als eine Aussparung in der Unterseite des Basiskörpers bereitgestellt. Es wird eine Art Rinne oder ein nach oben offener Kanal in der Oberseite und/oder ein nach unten offener Kanal in der Unterseite des Basiskörpers gebildet. In einer bevorzugten Ausgestaltung der Erfindung erstreckt sich der zweite Abschnitt des Kanals, ausgehend von der Mittelachse des Basiskörpers, vorzugsweise radial, in Richtung des Randes des Basiskörpers. Der Rand oder Mantel beschreibt hierbei die seitliche Wand dar, welche die Oberseite mit der Unterseite des Basiskörpers verbindet.

In einer Ausführungsform wird der Kanal durch den ersten und den zweiten Abschnitt gebildet. Insbesondere geht dabei der erste Abschnitt des Kanals in den zweiten Abschnitt des Kanals über. Der erste Abschnitt des Kanals mündet in den zweiten Abschnitt des Kanals. Dadurch wird, insbesondere zumindest abschnittsweise, ein im Wesentlichen L-förmiger Kanal gebildet. Die Schenkel des "L" werden durch den ersten und den zweiten Abschnitt gebildet. Der vorstehend genannte erste Abschnitt und der vorstehend genannte zweite Abschnitt des Kanals können daher auch als erster und zweiter Schenkel des Kanals bezeichnet werden.

Der Durchmesser des Kanals liegt im Allgemeinen bei etwa 0,25 mm² bis etwa 25 mm², bevorzugt bis etwa 9 mm², besonders bevorzugt bis etwa 3 mm².

Der wenigstens eine Anschlusskörper ist ein Anschlusskörper zum Bereitstellen eines elektrischen Anschlusses für das auf dem Basiskörper positionierte Funktionselement. Über den Anschlusskörper kann im Allgemeinen eine Verbindung der Oberseite des Basiskörpers und somit des Funktionselements mit der Umgebung hergestellt werden, vorzugsweise mittels eines Anschlusses über den Rand und/oder die Rückseite des Basiskörpers.

Der Anschlusskörper ist ein massiver Körper. Vorzugsweise kann dieser auch unter leichtem Druck, beispielsweise durch ein Pressen mit den Fingern, verformbar sein. Dieser stellt keine auf dem Basiskörper, zum Beispiel mittels eines PVD-Verfahrens, aufgebrachte oder aufgewachsene Schicht dar.

Vielmehr wird der Anschlusskörper als solcher zumindest abschnittsweise in dem Kanal positioniert. In einer ersten Ausführungsform wird zunächst der Anschlusskörper zumindest abschnittsweise in dem Kanal positioniert. Der Kanal wird dann mit dem Glas zum Verbinden des Anschlusskörpers mit dem Basiskörper zumindest abschnittsweise befüllt.

Der Anschlusskörper ist im Allgemeinen von dem Basiskörper elektrisch isoliert. Dieser ist zumindest abschnittsweise beabstandet von dem Basisköper angeordnet und/oder durch das Glas und die sich ausbildende Glasschicht getrennt. Der Anschlusskörper ist derart in dem Glas eingebettet oder positioniert, dass wenigstens zwei Kontaktstellen des Anschlusskörpers freiliegen, so dass der Anschlusskörper zum Beispiel über einen Draht kontaktiert werden kann. Vorzugsweise liegen das Kopfende und das Fußende des Anschlusskörpers frei. An dem freiliegenden Bereich kann zum Kontaktieren beispielsweise ein Draht ("Drahtbonden") und/oder eine Leiterbahn befestigt werden. Auch kann ein Funktionselement beispielsweise auf den Anschlusskörper an- oder aufgesetzt und vorzugsweise mittels eine leitfähigen Klebers befestigt sein. Es wird einem Kanal zumindest ein Anschlusskörper oder genau ein Anschlusskörper oder eine Vielzahl von Anschlusskörpern zugeordnet.

Der Anschlusskörper mündet in die Oberseite und/oder die Unterseite und/oder den Rand des Basiskörpers und ist dort mit weiteren Komponenten, beispielsweise an der Oberseite mit zumindest einem opto-elektronischen Funktionselement, verbindbar. Dabei kann der wenigstens eine Anschlusskörper im Wesentlichen mit der Oberfläche der Oberseite, der Unterseite und/oder des Rands des Basiskörpers abschließen und/oder sich über die Oberfläche der Oberseite, der Unterseite und/oder des Rands des Basiskörpers des Basiskörpers hinaus erstrecken.

Im Allgemeinen ist der Anschlusskörper in seiner Gestalt und/oder seinen Abmessungen an die Gestalt und/oder die Abmessungen des Kanals, dem er zugeordnet ist und/oder in dem er zumindest abschnittsweise angeordnet ist, angepasst. Insbesondere ist dabei der Anschlusskörper, vorzugsweise durchgehend, im Wesentlichen entsprechend dem Verlauf des Kanals geformt, zum Beispiel zumindest abschnittsweise I-förmig oder L-förmig. Der Anschlusskörper kann durch einen ersten und/oder einen zweiten Abschnitt definiert werden. Der erste Abschnitt des Anschlusskörpers verläuft im Wesentlichen entlang, vorzugsweise parallel zu, der Mittelachse des Basiskörper. Der zweite Abschnitt des Anschlusskörpers verläuft im Wesentlichen quer, vorzugsweise senkrecht, zu dem ersten Abschnitt.

Vorzugsweise ist der Anschlusskörper ein Kontaktstift. Ein Kontaktstift ist ein längliches, metallisches Bauteil mit einem im Verhältnis zu seiner Länge deutlich reduzierten Querschnitt. Es ist ein nadel- oder nagelartiges Bauteil. Dieses kann nur einen geraden Schenkel besitzen oder aber auch wenigstens einen gebogenen Abschnitt aufweisen. Somit kann der Kontaktstift, insbesondere zumindest abschnittsweise, als ein im Wesentlichen gerader Stift oder I-förmig bereitgestellt werden. Er kann aber, insbesondere zumindest abschnittsweise, auch als Haken oder L-förmig bereitgestellt sein. Unter einem Kontaktstift wird auch ein metallischer Draht verstanden.

Der Anschlusskörper umfasst oder ist ein Metall oder eine Legierung. Das Metall ist hierbei zumindest ein Mitglied ausgewählt aus der Gruppe von Kupfer, Aluminium, Nickel, Cobalt, Eisen, Stahl oder Edelstahl, ferritischen Stahl oder Edelstahl und austenitischen Stahl oder Edelstahl. Der Durchmesser des Anschlusskörpers, vorzugsweise des Kontaktstifts, liegt im Allgemeinen bei etwa 0,1 mm² bis etwa 16 mm², bevorzugt bis etwa 3 mm², besonders bevorzugt bis etwa 0,8 mm².

Das Glas ist ein Glas zum Verbinden des Basiskörpers mit dem Anschlusskörper und/oder zum Isolieren des Basiskörpers von dem Anschlusskörper. Das Glas besitzt einen Erweichungspunkt oder eine Erweichungstemperatur in einem Bereich, der unterhalb der Schmelztemperatur der Materialien liegt, die für den Basiskörper und/oder den Anschlusskörper verwendet werden. Das Glas wird für das Verbinden oder ist beim Verbinden insoweit erwärmt, dass es eine Viskosität besitzt, bei der die Bauteile aneinander haften. Vorzugsweise besitzt das Glas beim Verbinden eine Viskosität in einem Bereich von 10⁷ Pas bis etwa 10³ Pas. Die Erwärmung erfolgt zum Beispiel in einem Ofen. Vorzugsweise ist oder umfasst das verwendete Glas ein Phosphatglas und/oder ein Weichglas und/oder einer Alkali-Titan-Silikat-Glas. Beispiele für ein Phosphatglas sind die Gläser mit der Bezeichnung SCHOTT G018-122. Beispiele für ein Weichglas sind die Gläser mit der Bezeichnung SCHOTT 8061 und/oder SCHOTT 8421. Werden z.B. der Basiskörper und/oder der Anschlusskörper im Wesentlichen durch Kupfer und/oder Aluminium, insbesondere an der Grenzfläche zu dem Glas, bereitgestellt, so ist das Glas vorzugsweise ein Alkali-Titan-Silikat-Glas. Der Basiskörper und/oder der Anschlusskörper und/oder zumindest die Grenzflächen besitzt bzw. besitzen einen Anteil an Kupfer oder Aluminium von mindestens 50 Gew.%, vorzugsweise von mindestens 80 Gew.%.

In einer Ausführungsform besitzt das Alkali-Titan-Silikat-Glas die folgende Zusammensetzung (in Gewichtsprozent):
In einer bevorzugten Ausführungsform besitzt oder umfasst das Glas die eingangs in den Tabellen beschriebene Zusammensetzung.

Die mit dem Glas gebildete Glasschicht oder im Detail die zwischen dem Basiskörper und dem Anschlusskörper gebildete Glasschicht besitzt im Allgemeinen eine Dicke von größer als etwa 30 µm. Dadurch kann ein gasdichter Verbund mit ausreichend hohen elektrisch isolierenden Eigenschaften bereitgestellt werden. Vorzugsweise beträgt die Dicke der Glasschicht etwa 200 µm. bis etwa 2000 µm.

Der elektrische Widerstand der Glasschicht, welche auf dem Alkali-Titan-Silikat-Glas, insbesondere mit den genannten Zusammensetzungen, basiert, liegt im Allgemeinen bei größer als 1 G**Ω.** Die Gasdichtheit ist im Allgemeinen kleiner als 1*10⁻⁸ mbar*l/s. Weiterhin zeichnet sich das Glas aus durch eine verbesserte Festigkeit und eine verbesserte chemische Beständigkeit. So kann insbesondere die Scherfestigkeit bei einem Probekörper (4 mm x 4 mm Verglasungsfläche und 100 µm nominelle Dicke der Glasschicht) mit dem erfindungsgemäßen Glas von durchschnittlich 60 N auf 105 N erhöht werden gegenüber dem Glas P8061. Ferner weist das erfindungsgemäße Glas gegenüber dem Glas G018-122 (siehe dazu die WO 2009/132838 A1) eine verbesserte chemische Beständigkeit auf. Die Galvanik kann nach dem Verglasen durchgeführt werden.

Im Allgemeinen kann das Glas durch zumindest ein Verfahren aufgebracht werden, welches ausgewählt ist aus einer Gruppe bestehend aus Dispensen, Bereitstellen eines vorzugsweise gestanztes Glasbandes und/oder Bereitstellen eines individuellen Vorformlings. Ein Glasband kann zum Beispiel durch in die Form eines Bandes gegossenes Schlicker bereitgestellt werden. Um eine effiziente Herstellung zu erzielen, kann das Glas in einer Matrix bereitgestellt werden.

Für weitere mögliche Ausgestaltungen der Glasschicht oder des Glases und der Verfahren zum Verwenden eines Glases wird Bezug genommen auf die in dem Dokument WO 2009/132838 A1 beschriebene erste und/oder zweite Glasschicht.

Um ein verbessertes Anhaften des Anschlusskörpers an dem Basiskörper zu bewirken, erfolgt vorzugsweise eine Vorbehandlung der Glaskontaktflächen des Basiskörpers und/oder des Anschlusskörpers. Die genannte Vorbehandlung kann in einer Ausführungsform durch ein Voroxidieren der Glaskontaktflächen erfolgen. Unter dem Voroxidieren wird ein gezieltes Oxidieren einer Oberfläche, zum Beispiel in einer sauerstoffhaltigen Atmosphäre, verstanden. Dabei hat sich ein Verbund aus Glas und Kupfer oder Kupferoxid als sehr stabil erwiesen. Das Metall, vorzugsweise Kupfer, wird in einer sauerstoffhaltigen Atmosphäre gezielt oxidiert. Dabei hat sich für das Oxidgewicht ein Flächengewicht von etwa 0,02 bis etwa 0,25 mg/cm², vorzugsweise von etwa 0,067 bis etwa 0,13 mg/cm², Oxidgewicht als vorteilhaft erwiesen. Das Oxid haftet gut und blättert nicht ab. Dies ist insbesondere zutreffend, wenn das Kupfer mit einem Anteil von größer als 50 Gew.%, vorzugsweise von größer als 80 Gew.%, in dem Basiskörper und/oder in dem Anschlusskörper und/oder zumindest in den Grenzflächen bereitgestellt wird.

Zum Verbessern der Eigenschaften des Basiskörpers und/oder des Anschlusskörpers, beispielsweise der Reflektivität, der Bondbarkeit und/oder der elektrischen Leitfähigkeit, können diese, vorzugsweise zumindest abschnittsweise, beschichtet und/oder verkleidet sein, vorzugsweise mit einem Metall. Ein mögliches Verfahren stellt das Plattieren, vorzugsweise mittels Galvanotechnik, dar.

Das auf dem Basiskörper positionierbare opto-elektronische Funktionselement ist ein strahlungsemittierendes und/oder strahlungsempfangendes Bauteil. Vorzugsweise ist es als Chip ausgebildet. Das Funktionselement ist wenigstens ein Bauteil ausgewählt aus der Gruppe von LED, Photodiode und Laserdiode. Die Verwendung des erfindungsgemäßen Gehäuses ist insbesondere für LEDs mit einer hohen Leistung, vorzugsweise mit einer Leistung von größer als etwa 5 W geeignet, da bei diesen eine effiziente Wärmeableitung erforderlich ist und das Gehäuse ausreichend thermisch stabil sein muss. Insbesondere auch für nicht opto-elektronische Funktionselemente, wie zum Beispiel Leistungshalbleiter, deren Verwendung insbesondere eine ausreichende thermische Stabilität erfordert, kann das vorliegende erfindungsgemäße Gehäuse geeignet sein. Somit kann das erfindungsgemäße Gehäuse auch ein Gehäuse für ein opto-elektronisches Funktionselement und/oder allgemein für ein Funktionselement sein.

Eine weitere Ausgestaltung ist dadurch gekennzeichnet, dass zumindest die Oberseite des Basiskörpers wenigstens eine Vertiefung mit einem Boden aufweist. Der Montagebereich für zumindest ein opto-elektronisches Funktionselement ist durch den Boden der Vertiefung bereitgestellt. Ein in der Vertiefung angeordnetes Funktionselement ist besser geschützt als ein an einer ebenen Oberseite positioniertes Funktionselement. Vorzugsweise hat eine Innenseite der Vertiefung zumindest abschnittsweise reflektierende Eigenschaften, so dass durch die Vertiefung ein Reflektor für die von einem opto-elektronischen emittierte und/oder zu empfangende Strahlung gebildet wird. In einer bevorzugten Ausführungsform besitzt die Vertiefung einen Durchmesser, welcher ausgehend von dem Boden der Vertiefung, auf welchem wenigstens ein opto-elektronisches Funktionselement positionierbar ist, in Richtung der Oberseite der Vertiefung zunimmt. Vorzugsweise ist die Vertiefung zumindest abschnittsweise als ein Kegelstumpf und/oder ein Pyramidenstumpf ausgebildet, wobei der Boden der Vertiefung die Grundfläche des Kegelstumpfs und/oder des Pyramidenstumpfs bildet. Die Vertiefung kann definiert werden durch eine Grundseite, die hier als Boden bezeichnet ist, eine Deckseite und eine Mantelseite, die hier allgemein als Mantel bezeichnet ist. Im Allgemeinen besitzt die Vertiefung in einer Aufsicht auf die Oberseite des Basiskörpers eine Fläche von etwa 4 mm² bis etwa 50 mm², vorzugsweise bis etwa 20 mm². Die Tiefe liegt im Allgemeinen bei etwa 0,2 mm bis etwa 2 mm.

In einer Weiterbildung mündet der wenigstens Kanal in die wenigstens eine Vertiefung, insbesondere in einen Mantel der Vertiefung. Durch diese Art der Anordnung wird eine räumliche Nähe des Anschlusskörpers zu dem Funktionselement bereitgestellt, was in eine reduzierte Rauschempfindlichkeit resultieren kann.

Das Gehäuse weist in einer Weiterbildung in der Oberseite des Basiskörpers einen Aufnahmebereich zur Aufnahme und/oder zum Lagern eines Abschlusselements, wie zum Beispiel eines optischen Bauelements, auf. Auf der Oberseite des Basiskörpers und dabei vorzugsweise in den Aufnahmebereich, ist bzw. wird gegebenenfalls wenigstens ein, vorzugsweise transparentes, Abschlusselement aufgebracht. Das Abschlusselement ist insbesondere ein optisches Bauelement. Ein Beispiel für das optische Bauelement ist ein fokussierendes Bauteil, vorzugsweise eine Linse. Die Linse kann bereitgestellt werden durch eine vorzugsweise konvexe Glaslinse und/oder einen Tropfen, wie zum Beispiel ein Silikontropfen.

In Abhängigkeit von den Anforderungen kann das Gehäuse gemäß der Erfindung unterschiedlich ausgeführt sein: Zum Beispiel kann der Basiskörper eine Vertiefung und einen Kanal oder zwei Kanäle haben. Der Basiskörper kann aber auch eine Vielzahl von Kanälen und/oder eine Vielzahl von Vertiefungen haben.

Nachfolgend sind einige Ausführungsformen beschrieben, die sich auf eine Vielzahl von Kanälen und/oder eine Vielzahl von Vertiefungen in dem Basiskörper beziehen:
In einer ersten Ausgestaltung ist zumindest ein Teil aus der Vielzahl der Kanäle und/oder zumindest ein Teil aus der Vielzahl der Vertiefungen zumindest abschnittsweise um den Montagebereich herum verteilt, beispielsweise auf einem Kreis, angeordnet. Vorzugsweise sind die Kanäle und/oder die Vertiefungen, welche zueinander benachbart sind, im Wesentlichen äquidistant zueinander angeordnet. In einer zweiten Ausgestaltung ist ein Kanal aus der Vielzahl der Kanäle und/oder eine Vertiefung aus der Vielzahl der Vertiefungen auf der Mittelachse des Basiskörpers angeordnet und die restlichen Kanäle aus der Vielzahl der Kanäle und/oder die restlichen Vertiefungen aus der Vielzahl der Vertiefungen sind um die Mittelachse des Basiskörpers herum verteilt angeordnet.

Da im Allgemeinen jeweils zwei Anschlüsse zum Betrieb eines Funktionselements erforderlich sind, ist das Gehäuse in einer weiteren Ausgestaltung dadurch gekennzeichnet, dass die Kanäle aus der Vielzahl der Kanäle zumindest teilweise paarweise angeordnet sind. Vorzugsweise ist hierbei jeder Vertiefung aus der Vielzahl der Vertiefungen wenigstens ein Paar von Kanälen zugeordnet.

In einer weiteren Ausgestaltung des Gehäuses wird zumindest auf seiner Unterseite eine Isolation aufgebracht. Dazu wird auf der Unterseite des Basiskörpers und gegebenenfalls auf der Unterseite des wenigstens einen Anschlusskörpers noch eine Isolation, die vorzugsweise durch eine isolierende Schicht bereitgestellt wird, aufgebracht. Die genannte Isolation kann durchgehend oder auch segmentiert sein. Das Material für die Isolation ist oder umfasst vorzugsweise ein Glas und/oder eine Keramik. Die Schicht kann zum Beispiel über ein Emaillieren und/oder ein Cold-Spray-Verfahren aufgebracht werden. Dadurch ist die Unterseite des Gehäuses oder des Basiskörpers potentialfrei bereitstellbar.

In einer weiteren Ausgestaltung des Gehäuses ist eine Hülse mantelseitig an dem Basiskörper angeordnet. Die Hülse oder Hülle erstreckt sich zumindest abschnittsweise über den Umfang des Basiskörpers. Die Hülse ist vorzugsweise über eine Glasschicht am Basiskörper befestigt. Die Glasschicht befindet sich zwischen dem Basiskörper und der Hülse. Vorzugsweise wird die Hülse als eine metallische Hülse, zum Beispiel aus Edelstahl, bereitgestellt. Dadurch ist es möglich, die Außenseite des Gehäuses mit einem definierten Potential, beispielsweise mit dem Erd- bzw. Nullpotential, bereitzustellen.

Der Basiskörper und insbesondere auch die an und/oder in dem Basiskörper angeordneten Kanäle und/oder auch der Anschlusskörper werden durch ein Leiterrahmen-Verfahren hergestellt. Beispiele für ein solches Fertigungsverfahren stellen photochemisches Ätzen, Stanzen, Laser-Schneiden und/oder Wasserstrahlschneiden dar. Das Stanzen ist sehr kostengünstig und stellt daher das bevorzugte Verfahren zur Herstellung der genannten Bauteile dar. Somit werden auch in einer bevorzugten Ausführungsform der Erfindung im Wesentlichen nur stanzbare Metalle zur Herstellung des Basiskörpers mit dem wenigstens einen Kanal und/oder des Anschlusskörpers verwendet. In einer Ausführungsform wird eine Platte derart strukturiert, dass eine Vielzahl von Bauteilen pro Platte entsteht. Das Gehäuse ist Bestandteil einer Matrix von einzelnen Gehäusen. Eine Matrix ist dann eine Art Grundkörper, in welchem die jeweiligen Bauteile eingelagert oder angeordnet sind. Daher liegt im Bereich der vorliegenden Erfindung auch ein Anordnung oder eine Matrix, welche eine Vielzahl von Gehäusen, vorzugsweise der vorstehend beschriebenen Gehäuse, umfasst. Die einzelnen Gehäuse sind über Stege oder Verbindungsstege an der jeweiligen Matrix befestigt. Nach deren Herstellung werden die Gehäuse von der Matrix separiert.

Weiterhin erstreckt sich die Erfindung auf ein opto-elektronisches Bauteil, welches ein erfindungsgemäßes Gehäuse und wenigstens ein strahlungsemittierendes und/oder strahlungsempfangendes opto-elektronisches Funktionselement, insbesondere eine LED, das in dem Gehäuse angeordnet ist, umfasst.

Ferner liegt im Rahmen der vorliegenden Erfindung auch eine Beleuchtungseinrichtung, zum Beispiel eine Innenbeleuchtung und/oder eine Außenbeleuchtung, welche wenigstens ein Gehäuse und/oder ein opto-elektronisches Bauteil gemäß der vorliegenden Erfindung beinhaltet, insbesondere zum Einsatz in einem Fahrzeugen und/oder einem Flugzeug und/oder als Flugfeldbeleuchtung. Beispiele für die Beleuchtungseinrichtung sind eine Sitzbeleuchtung; ein Leselicht; eine Arbeitsleuchte, die insbesondere in Decken oder Wänden integrierbar ist; eine Objektbeleuchtung in Möbeln und/oder Gebäuden; ein Scheinwerfer und/oder ein Rücklicht und/oder eine Innenbeleuchtung und/oder eine Instrumenten- oder Display-Beleuchtung, vorzugsweise in Kraftfahrzeugen; eine Hintergrundbeleuchtung für LCD-Displays; eine UV-Beleuchtung, vorzugsweise in der Medizin und/oder zur Wasserreinigung; und/oder eine Beleuchtung für eine raue Umgebung ("harsh environment"), wie zum Beispiel unter Feuchtigkeitseinfluss und/oder aggressivem Gaseinfluss und/oder unter Strahlungseinfluss.

Die vorliegende Erfindung wird anhand der nachfolgenden Ausführungsbeispiele im Einzelnen erläutert. Hierzu wird auf die beigefügten Zeichnungen Bezug genommen. Die gleichen Bezugszeichen in den einzelnen Zeichnungen beziehen sich auf die gleichen Teile.

Fig. 1.a bis 1.d illustrieren eine Ausführungsform eines 3-lagigen Gehäuses in einer perspektivischen Ansicht auf die Oberseite (Fig. 1.a), einer Aufsicht auf die Oberseite (Fig. 1.b) und in einem Querschnitt entlang der Längsachse A-A (Fig. 1.c und 1.d).

Fig. 2.a bis 2.c illustrieren eine Ausführungsform eines 1-lagigen Gehäuses mit einem mantelseitig an dem Basiskörper montierten Anschlusskörper in einer Aufsicht auf die Oberseite (Fig. 2.a), in einem Querschnitt (Fig. 2.b) und in einem Querschnitt mit aufgesetzten Abschlusselement (Fig. 2.c).

Fig. 3.a bis 3.b zeigen eine weitere Ausführungsform eines 1-lagigen Gehäuses in einer perspektivischen Ansicht (Fig. 3.a), in einem Querschnitt (Fig. 3.b) und in einer Aufsicht auf die Oberseite (Fig. 3.c).

Fig. 4.a bis 4.c zeigen eine modifizierte Ausführungsform eines 1-lagigen Gehäuses in einer perspektivischen Ansicht (Fig. 4.a), in einem Querschnitt (Fig. 4.b) und in einer Aufsicht auf die Oberseite (Fig. 4.c).

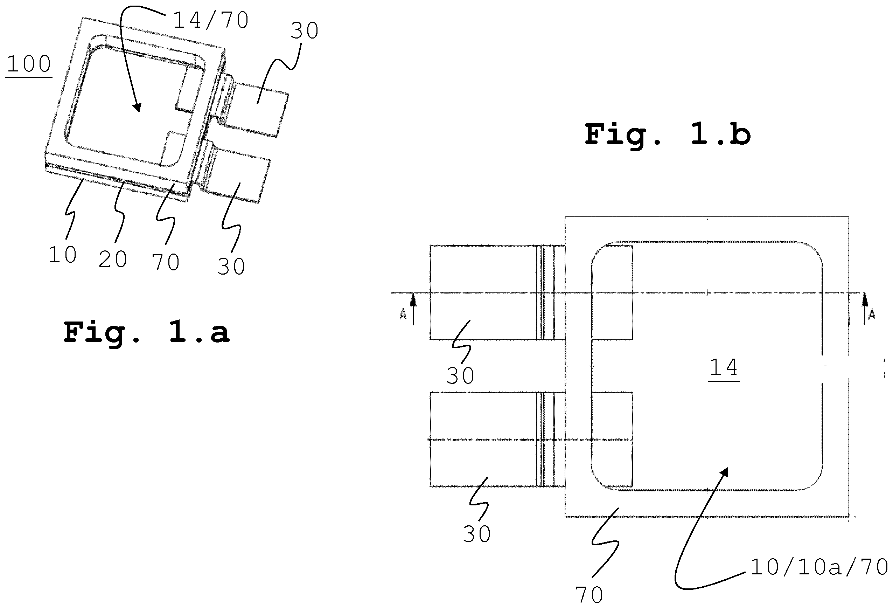

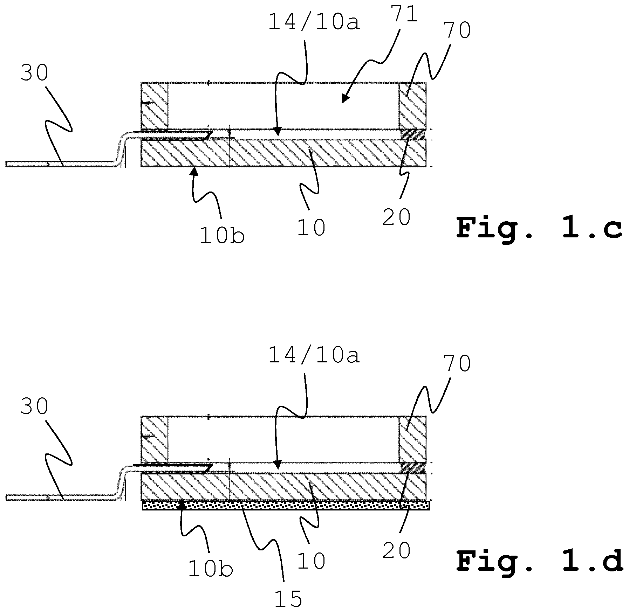

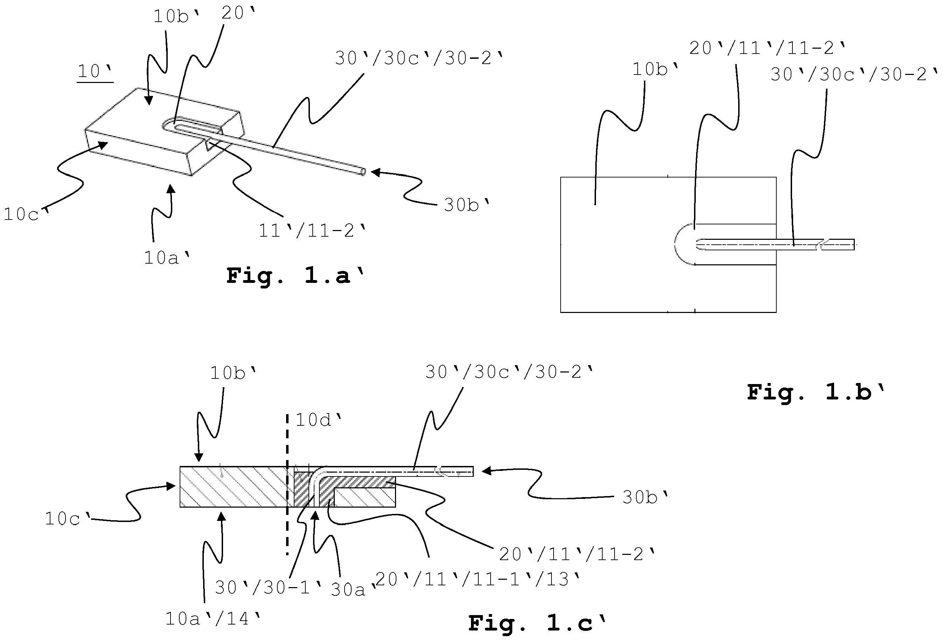

Die Figuren 1.a bis 1.d zeigen eine erste Ausführungsform eines 3-lagigen oder zumindest 3-lagigen Gehäuses 100. Das Gehäuse 100 besteht wenigstens aus einem Basiskörper 10, wenigstens oder genau zwei Anschlusskörpern 30 und einem Kopfteil 70. Der Basiskörper 10 und das Kopfteil 70 sind über eine Glasschicht 20 stoffschlüssig miteinander verbunden.

Die zwei dargestellten Anschlusskörper 30 sind zwischen dem Basiskörper 10 und dem Kopfteil 70 angeordnet. Im Detail sind sie innerhalb der Glasschicht 20 angeordnet. Die eine Glasschicht 20 kann auch durch zwei getrennte Glasschichten realisiert sein, wobei die beiden Anschlusskörper 30 dann zwischen den beiden Schichten angeordnet sind. Dadurch sind die zwei Anschlusskörper 30 sowohl von dem Basiskörper 10 als auch von dem Kopfteil 30 elektrisch isoliert. Die beiden Anschlusskörper 30 erstrecken sich durch die Glasschicht 20. Sie stellen eine elektrische Verbindung oder zwei elektrische Anschlüsse zwischen dem Innenraum und dem Außenraum des Gehäuses 100 bereit. Die wenigstens zwei oder zwei Anschlussköper 30 sind zusammen auf einer Seite des Gehäuses 100 oder auf der gleichen Seite des Gehäuses 100 positioniert. Sie sind in einer Ebene angeordnet. Die Anschlusskörper 30 sind hier zwei metallische Platten, vorzugsweise Kupferplatten. Sie sind biegbar oder wie hier dargestellt gebogen, so dass zum Beispiel ein Kontakt zu einer Leiterbahn einer Platine, auf die das Gehäuse 100 im Betriebszustand aufgesetzt wird, herstellbar ist.

Der Basiskörper 10 hat eine Oberseite 10a, eine Unterseite 10b und einen Rand oder Mantel 13. Im gezeigten Beispiel hat der Basiskörper 10 einen eckigen, vorzugsweise einen quadratischen, Querschnitt. Der Querschnitt kann aber auch rund, vorzugsweise kreisförmig oder oval, sein. Der Basiskörper 10 ist ebenso insbesondere als eine metallische Platte, vorzugsweise eine Kupferplatte, ausgeführt. An der Oberseite 10a des Basiskörpers 11 ist der Montagebereich 14 für wenigstens ein elektronisches Funktionselement 40, wie zum Beispiel für ein Bauteil der Leistungselektronik, definiert. Ein Beispiel stellt ein FET dar. Der Montagebereich 14 wird bereitgestellt durch die Oberseite 10a des Basiskörpers 10.

Das Kopfteil 70 ist auf dem Basiskörper 10, im Detail auf der Oberseite 10a des Basiskörpers 10 angeordnet. Es hat im Wesentlichen die gleichen Abmessungen wie der Basiskörper 10. Das Kopfteil 70 ist insbesondere als eine metallische Platte, vorzugsweise eine Kupferplatte, ausgeführt. Das Kopfteil 50 bedeckt abschnittsweise den Basiskörper 10. Es muss aber nicht zwangsläufig den Abschluss des Gehäuses 100 zu seiner Oberseite hin bilden. Es bildet, insbesondere zumindest, einen Abschnitt einer Gehäusewand oder die Gehäusewand. Das Kopfteil 50 kann auch als Gehäusewand oder Rahmen bezeichnet werden. Das Kopfteil 50 umgibt den Montagebereich 14, insbesondere zumindest, abschnittsweise oder vollständig. Es wird eine Öffnung 51 oder Loch 51 im Kopfteil 50 gebildet. Das zu montierende Funktionselement 40 ist dann in dem Loch 51 oder innerhalb des Kopfteils 50 angeordnet. Die Öffnung 51 hat einen eckigen, vorzugsweise quadratischen, Querschnitt. Der Querschnitt kann auch rund, vorzugsweise kreisförmig oder oval, sein. Das Kopfteil 50 kann eine Art Abdeckung für das Basisteil 10 darstellen. Es kann auch auf dem Kopfteil 50 zusätzlich ein Deckel zum Verschließen des Gehäuses 100 vorgesehen sein.

Zwischen der Oberseite 10a des Basiskörpers 10 und dem Kopfteil 70 ist die Glasschicht 20 angeordnet. Diese verbindet den Basiskörper 10 mit dem Kopfteil 70. Das Glas ist ein Alkali-Titan-Silikat-Glas. Hier beträgt die Dicke der Glasschicht etwa 30 µm. bis etwa 500 µm, vorzugsweise etwa 100 µm bis etwa 300 µm.

Figur 1.d zeigt die gleiche Ausgestaltung wie in Figur 1.c. Zusätzlich ist auf der Unterseite 10b des Basiskörper 10 und gegebenenfalls auf der Unterseite des Anschlusskörpers 30 noch eine Isolation 15, insbesondere eine isolierende Schicht 15, aufgebracht. In dem gezeigten Beispiel ist die Unterseite 10b des Basiskörpers 10 vollständig oder im Wesentlichen vollständig mit der Isolation 15 bedeckt. Die metallischen Bauteile, hier nur die Unterseite 10b des Basiskörper 10, sind mit der Isolation 15 bedeckt. Dadurch ist die Unterseite des Gehäuses 100 potentialfrei bereitstellbar.

In der vorstehend beschriebenen Ausführungsform sind der Basiskörper 10 und der bzw. die Anschlusskörper 30 über eine Glasschicht 20 verbunden, welche sich im Wesentlichen auf der Oberseite 10a des Basiskörpers 10 befindet. Die nachfolgend beschriebenen Ausführungsformen zeigen dagegen ein Gehäuse 100, in welchem der Basiskörper 10 und der Anschlusskörper 30 über eine Glasschicht 20 verbunden sind, welche zwischen dem Rand oder Mantel 13 des Basiskörpers 10 und dem Anschlusskörper 30 angeordnet ist. Der Anschlusskörper 30 ist mantel- oder randseitig an dem Basiskörper 10 befestigt. Das Glas ist wiederum ein Alkali-Titan-Silikat-Glas. Die Dicke der Glasschicht beträgt etwa 200 µm bis etwa 2000 µm.

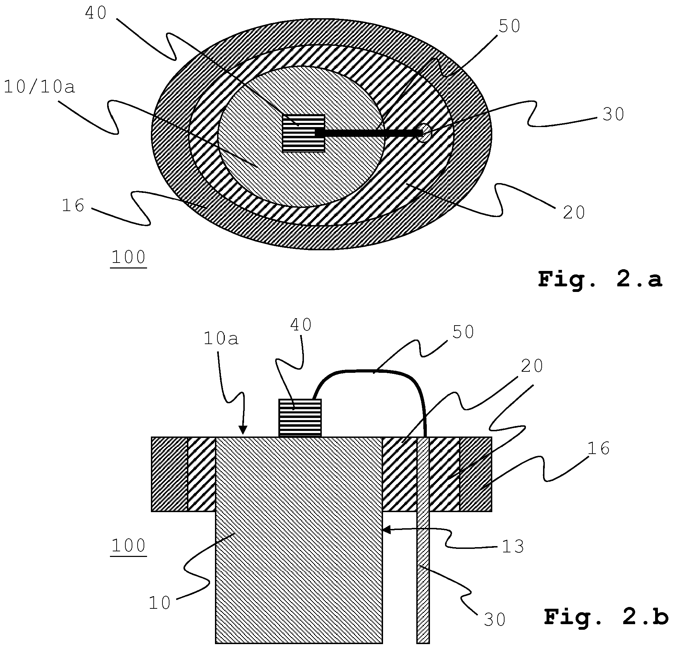

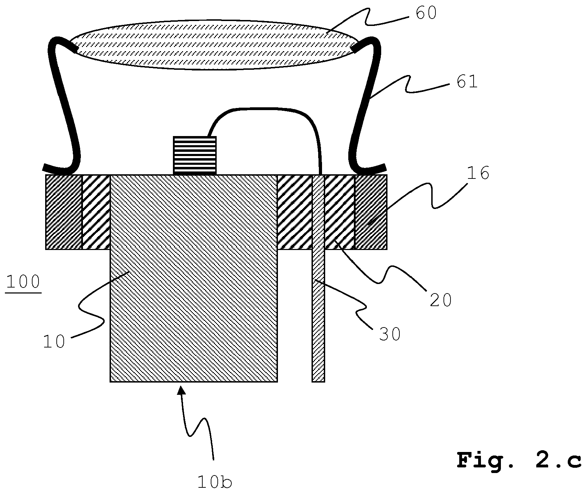

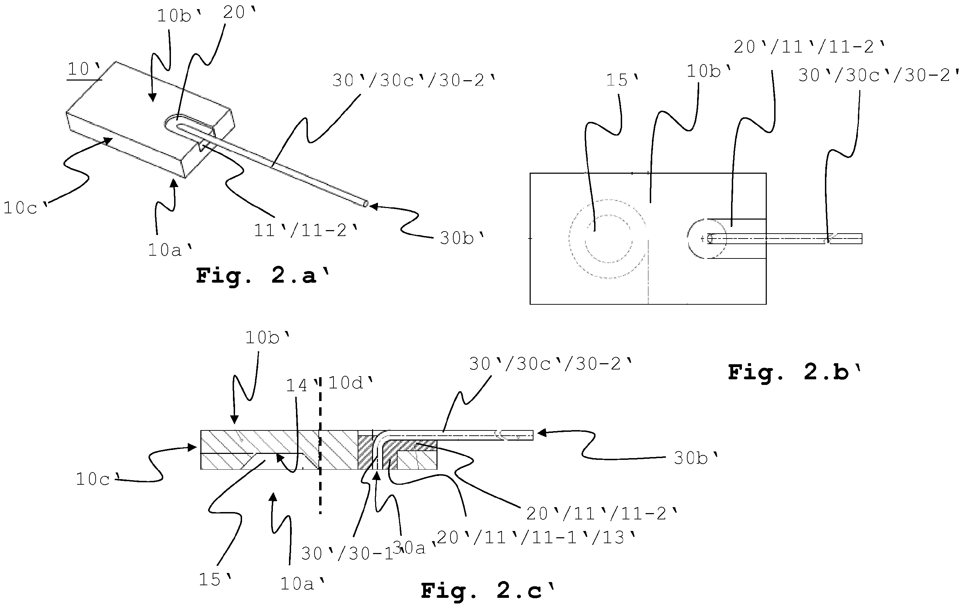

Die Figuren 2.a bis 2.c eine Ausführungsform eines Gehäuses 100 mit einem am Mantel 13 des Basiskörpers 10 montierten Anschlusskörper 30. Der Anschlusskörper 30 ist beispielhaft als ein Kontaktstift 30 ausgeführt. Die Glasschicht 20 ist in dieser Variante des Gehäuses 100 an der Außenseite des Mantels 13 positioniert. Die Glasschicht 20 bedeckt den Mantel 13 nur abschnittsweise. Der Basiskörper 30 erstreckt sich nach unten hin über die Glasschicht 20 hinaus. Der Kontaktstift oder Anschlusskörper 30 befindet sich in oder innerhalb der Glasschicht 20 oder ist in diese zumindest abschnittsweise eingebettet. Er besitzt eine Länge, die größer ist als die Höhe der Glasschicht 20. In einem oberen Bereich ist der Anschlusskörper 30 vollständig über seinen Umfang von der Glasschicht 20 umgeben. Dagegen liegt der Anschlusskörper 30 in einem unteren Abschnitt vollständig frei. An der Außenseite der Glasschicht 20 ist ein rohrförmiger Abschnitt oder eine Hülse 16 positioniert. Die Hülse 16 erstreckt sich vollständig über den Umfang der Glasschicht 20 oder den Umfang des Gehäuses 100. Die Hülse 16 ist vorzugsweise eine metallische Hülse, zum Beispiel aus Edelstahl. Dadurch ist es möglich, die Außenseite des Gehäuses 100 potentialfrei bereitzustellen. Es wird durch die Hülse 16 ein potentialfreier Außenleiter oder eine Abschirmung gebildet.

Im Querschnitt ist zu erkennen, dass eine Art I-förmiger Glasverbund gebildet wird. Es wird eine Art Ring-in-RingSystem um den Basiskörper 10 herum gebildet. Dabei stellt die verbindende Glasschicht 20 einen ersten Ring und die Hülse 16 einen zweiten Ring dar. Sie sind zusammen um den Basiskörper 10 herum angeordnet. Die Glasschicht 20 oder 22 und die Hülse 16 erstrecken sich hier vollständig und/oder kontinuierlich über den Umfang des Basiskörpers 10. Der Querschnitt des Gehäuses 100 ist hier beispielhaft rund, insbesondere oval, dargestellt. Der Querschnitt kann aber auch allgemein rund oder eckig sein.

Figur 2.c entspricht der Figur 2.b. Zusätzlich ist jedoch auf der Oberseite 10a des Basiskörpers 10 noch eine Linse als Abschlusselement 60 angeordnet. Diese ist mittels der Halterung 61 beabstandet von seiner Oberseite 10a an dem Basiskörper 10 befestigt. Die Halterung 61 ist zum Beispiel bereitgestellt durch einen weiteren rohrförmigen Abschnitt oder eine weitere Hülse. Die Halterung 61 ist hier auf der Oberseite der Hülse 16 aufgesetzt. Diese Ausführungsform ist insbesondere für eine LED als Funktionselement 40 geeignet. Das Funktionselement 40 ist über den Bonddraht 50 mit dem Anschlusskörper 30 verbunden. Der Anschlusskörper 30 stellt einen ersten Anschluss bereit. Ein zweiter Anschluss wird durch den Basiskörper 10 bereitgestellt.

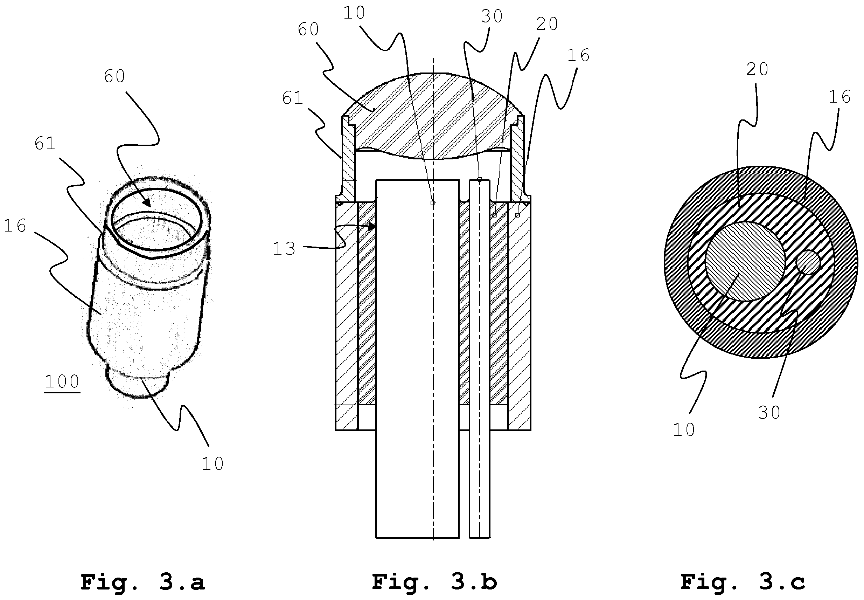

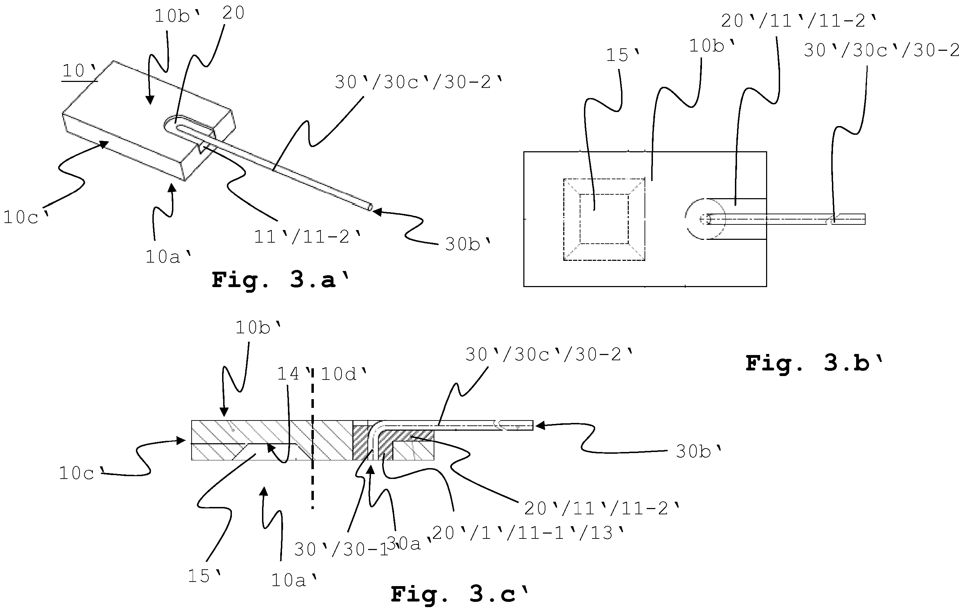

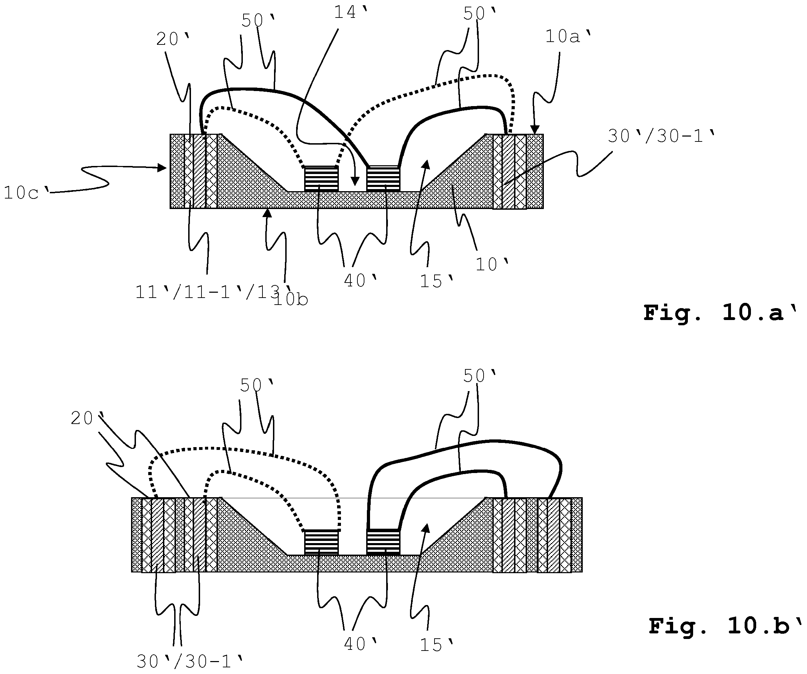

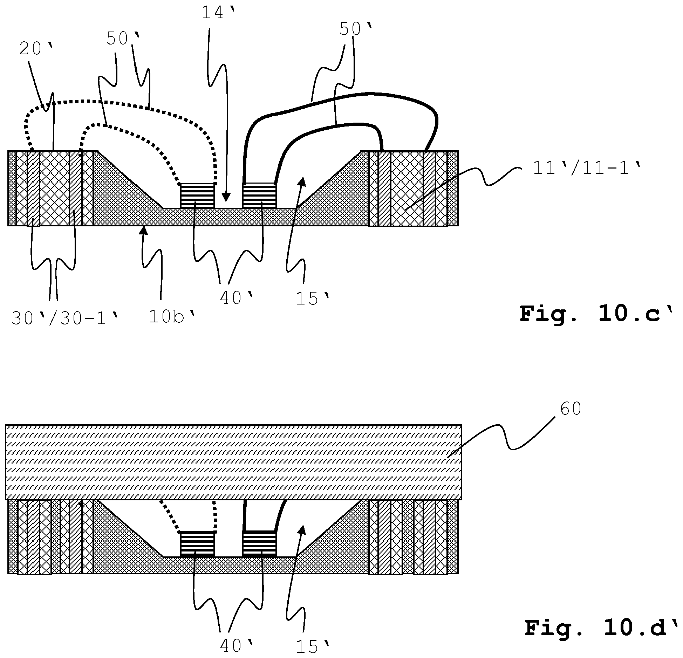

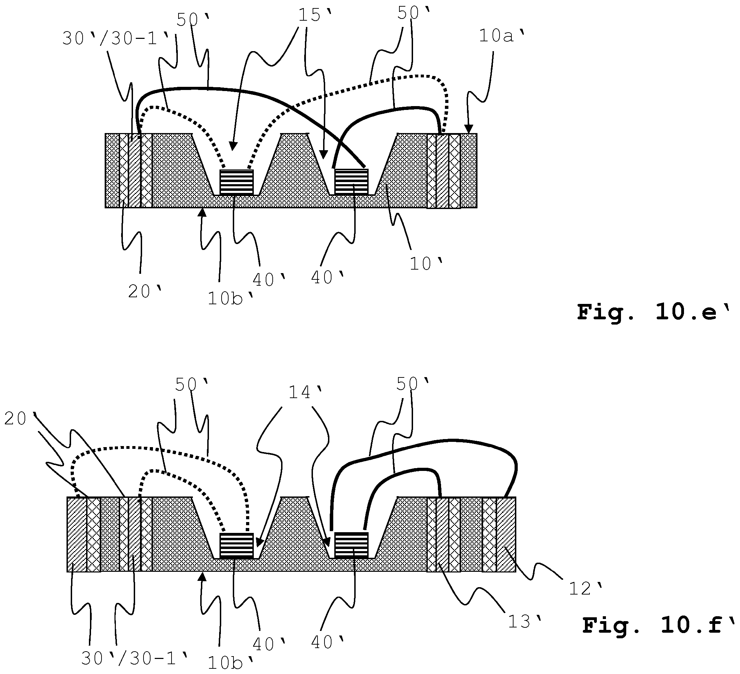

Die Figuren 3.a bis 3.c zeigen eine gegenüber den Figuren 2.a bis 2.c modifizierte Ausführungsform eines 1-lagigen Gehäuses 100. Zum einen ist der Querschnitt des Gehäuses 100 nicht mehr oval sondern kreisförmig. Zudem schließen der Basiskörper 10 und der Anschlusskörper 30 nicht mehr mit der Oberseite der Hülse 16 und der Oberseite der Glasschicht 20 ab. Die beiden erstrecken sich entlang der Längsachse des Gehäuses 100 zu der Oberseite hin und zu der Unterseite hin über die Hülse 16 und die Glasschicht 20 hinaus. Dadurch sind diese einfach zu kontaktieren. Figur 10.c zeigt eine Blick auf die Oberseite des Gehäuses 100 ohne die Bauteile 60 und 61. Der Basiskörper 10 und/oder der Anschlusskörper 30 erstrecken sich etwa 1 mm bis etwa 10 mm, vorzugsweise bis etwa 5 mm, über die Unterseite der Hülse 16 hinaus. Vorzugsweise liegt die Höhe und/oder der Durchmesser der Hülse 16 in einem Bereich von etwa 3 mm bis etwa 10 mm.

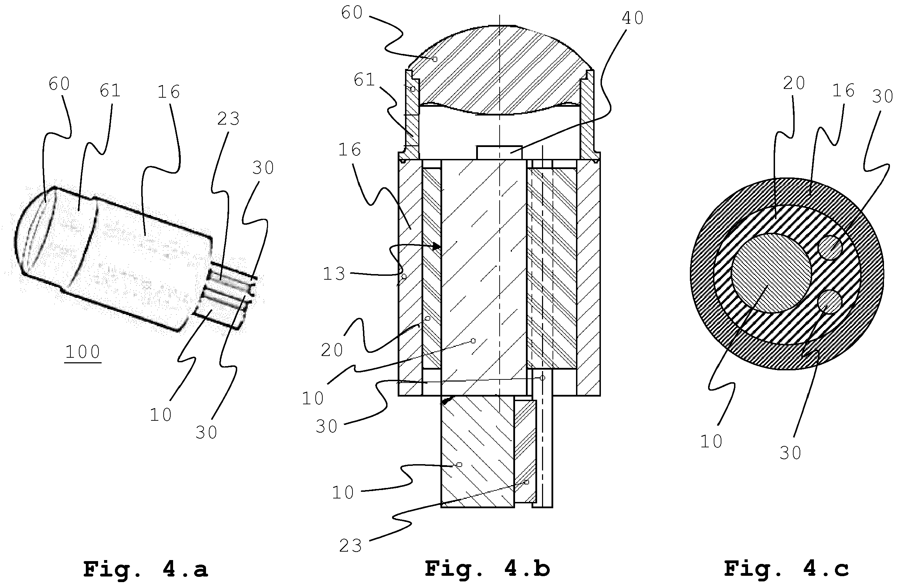

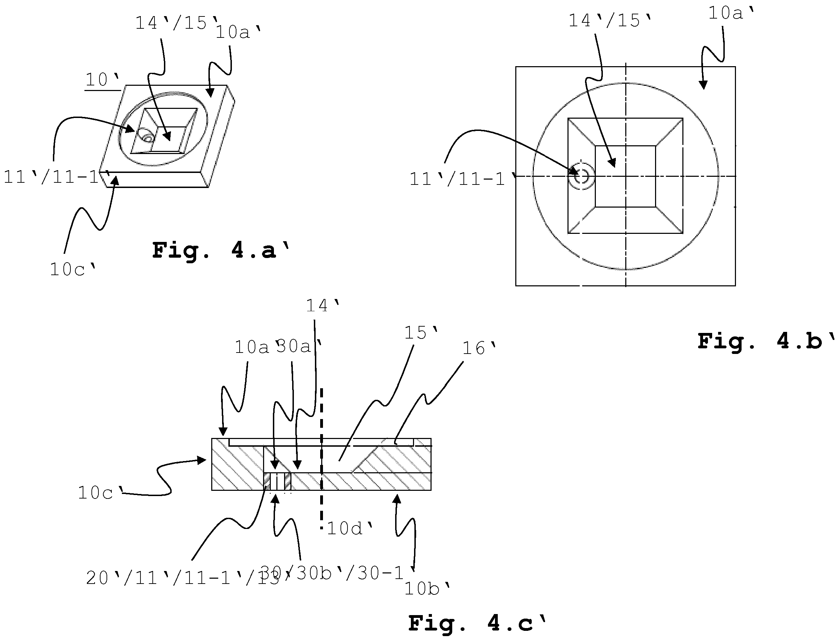

Die Figuren 4.a bis 4.c zeigen eine weitere modifizierte Ausführungsform eines 1-lagigen Gehäuses 100. In dieser Ausgestaltung sind zwei Anschlusskörper 30 vorgesehen. Somit können, in Verbindung mit dem Basiskörper 10, zum Beispiel zwei LEDs 40 getrennt angesteuert werden. Der Basiskörper 10 und die zwei Anschlusskörper 30 erstrecken sich zur Oberseite hin über die Glasschicht 20 hinaus. Sie schließen aber mit der Hülse 16 ab. Der Basiskörper 10 ist in dem Beispiel 2-teilig ausgeführt. Er wird durch einen oberen Körper und einen unteren Körper bereitgestellt. Zwischen dem unteren Körper oder Abschnitt des Basiskörpers 10 und den beiden Anschlusskörpern 30 ist noch ein weitere Isolation 23, zum Beispiel durch Glas, vorgesehen.

Die in den Figuren 2.a bis 4.c dargestellten Gehäuse 100 sind insbesondere geeignet für Stecksockelanwendungen. Denn der sich nach unten erstreckenden Basiskörper 10 und der oder die sich nach unten erstreckende(n) Anschlusskörper 30 kann bzw. können zum Anschließen einfach in einen Sockel, welcher zum Beispiel die Spannungsversorgung bereitstellt, eingesteckt werden. Die ist zum Beispiel für die Anwendung einer LED als Glühlampe geeignet.

Bezug nehmend auf die folgenden Zeichnungen Fig. 1' bis Fig. 10' sollen Ausführungsbeispiele eines Gehäuses näher erläutert werden.

Fig. 1.a' bis 1.c' illustrieren eine erste Ausführungsform eines 1-lagigen Gehäuses mit einem einzelnen Stift-Kontakt in einer perspektivischen Ansicht auf die Unterseite (Fig. 1.a'), einer Aufsicht auf die Unterseite (Fig. 1.b') und in einem Querschnitt (Fig. 1.c').

Fig. 2.a' bis 2.c' illustrieren eine zweite Ausführungsform eines 1-lagigen Gehäuses mit einem einzelnen Stift-Kontakt in einer perspektivischen Ansicht auf die Unterseite (Fig. 2.a'), einer Aufsicht auf die Unterseite (Fig. 2.b') und in einem Querschnitt (Fig. 2.c').

Fig. 3.a' bis 3.c' illustrieren eine dritte Ausführungsform eines 1-lagigen Gehäuses mit einem einzelnen Stift-Kontakt in einer perspektivischen Ansicht auf die Unterseite (Fig. 3.a'), einer Aufsicht auf die Unterseite (Fig. 3.b') und in einem Querschnitt (Fig. 3.c').

Fig. 4.a' bis 4.c' illustrieren eine vierte Ausführungsform eines 1-lagigen Gehäuses mit einem einzelnen Stift-Kontakt in einer perspektivischen Ansicht auf die Oberseite (Fig. 4.a'), einer Aufsicht auf die Oberseite (Fig. 4.b') und in einem Querschnitt (Fig. 4.c').

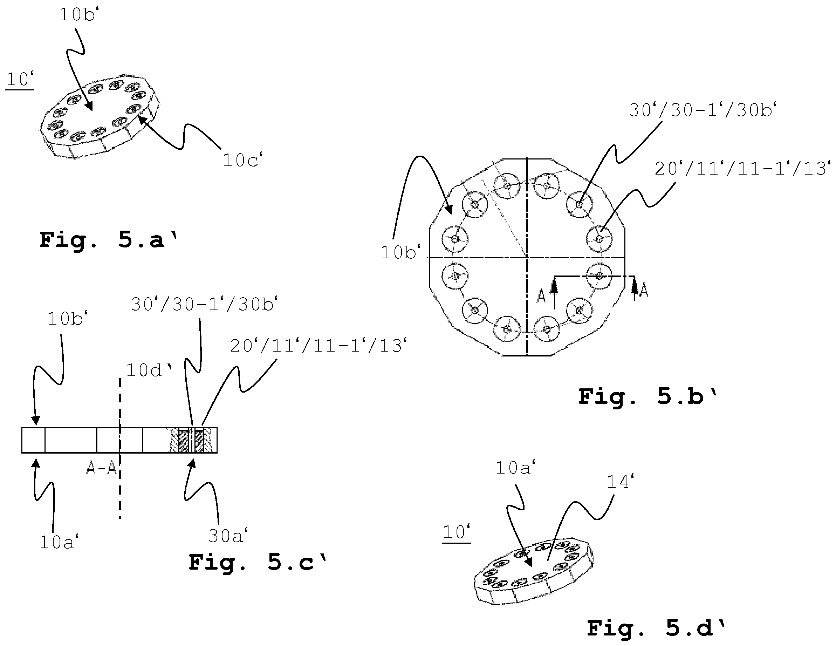

Fig. 5.a' bis 5.d' illustrieren eine erste Ausführungsform eines 1-lagigen Gehäuses mit mehreren Stift-Kontakten in einer perspektivischen Ansicht auf die Unterseite (Fig. 5.a') und die Oberseite (Fig. 5.d'), einer Aufsicht auf die Unterseite (Fig. 5.b') und in einem Querschnitt entlang der Achse A-A (Fig. 5.c').

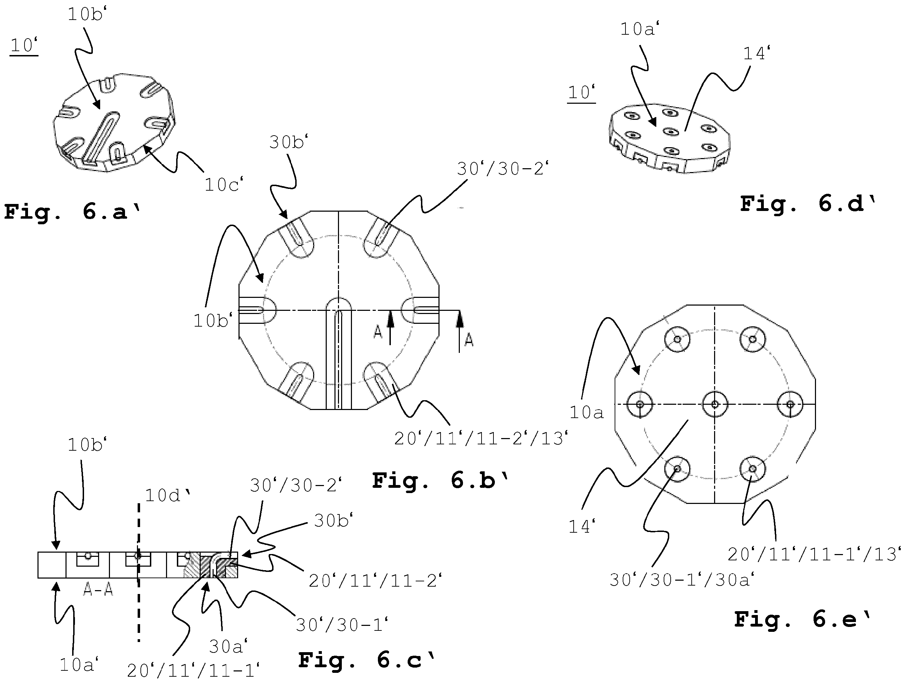

Fig. 6.a' bis 6.e' illustrieren eine zweite Ausführungsform eines 1-lagigen Gehäuses mit mehreren Stift-Kontakten in einer perspektivischen Ansicht auf die Unterseite (Fig. 6.a') und die Oberseite (Fig. 6.d), einer Aufsicht auf die Unterseite (Fig. 6.b') und die Oberseite (Fig. 6.e') sowie in einem Querschnitt entlang der Achse A-A (Fig. 6.c').

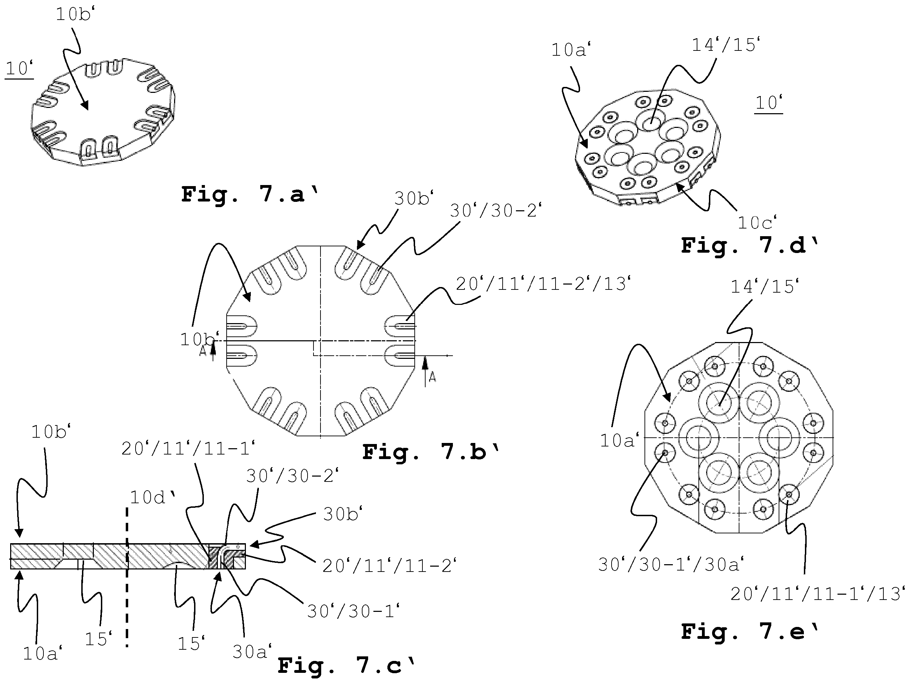

Fig. 7.a' bis 7.e' illustrieren eine dritte Ausführungsform eines 1-lagigen Gehäuses mit mehreren Stift-Kontakten in einer perspektivischen Ansicht auf die Unterseite (Fig. 7.a') und die Oberseite (Fig. 7.'), einer Aufsicht auf die Unterseite (Fig. 7.b') und die Oberseite (Fig. 7.e') sowie in einem Querschnitt entlang der Achse A-A (Fig. 7.c').

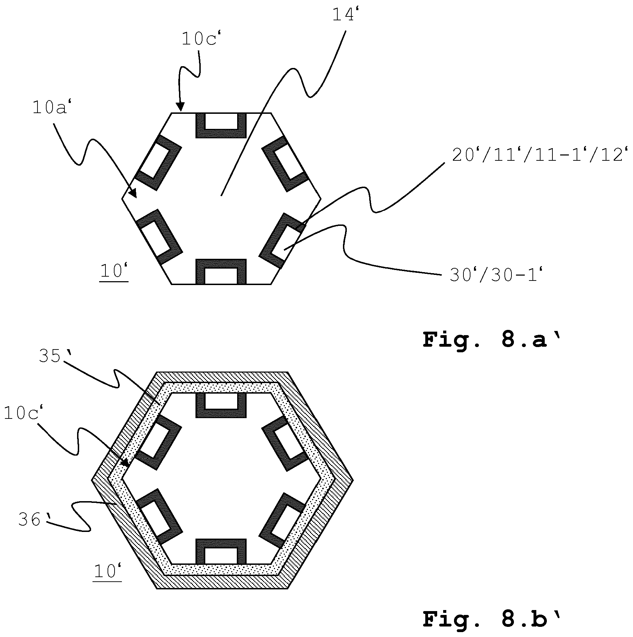

Fig. 8.a' und 8.b' illustrieren eine vierte Ausführungsform eines 1-lagigen Gehäuses mit mehreren Stift-Kontakten in einer Aufsicht auf die Oberseite ohne (Fig. 8.a') und mit einem mantelseitig angeordneten Außenleiter (Fig. 8.b').

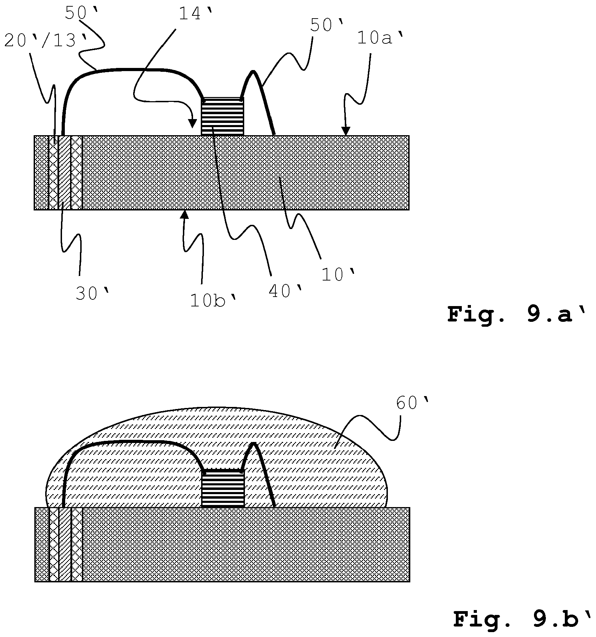

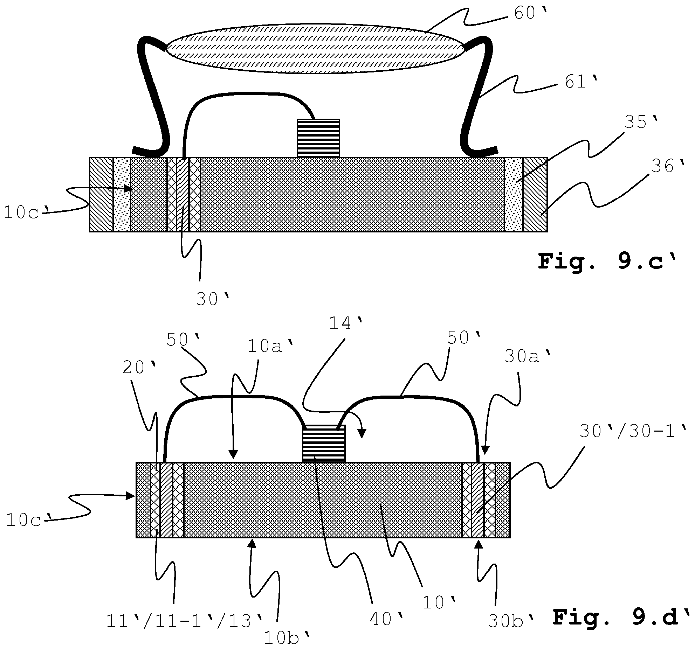

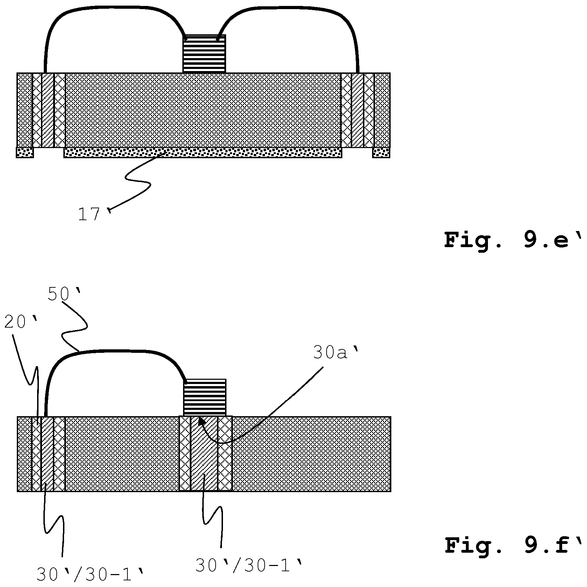

Fig. 9.a' bis 9.f' illustrieren einige Ausführungsformen eines erfindungsgemäßen 1-lagigen Gehäuses mit jeweils einem in dem Gehäuse positionierten Funktionselement.

Fig. 10.a' bis 10.f' illustrieren einige Ausführungsformen eines erfindungsgemäßen 1-lagigen Gehäuses mit zwei in dem Gehäuse positionierten Funktionselementen.

Die Figuren illustrieren durchgehend einen Anschlusskörper 30', welcher als Kontaktstift 30' ausgeführt ist. Zunächst zeigen die Figuren 1.a' bis 1.c' eine erste Ausführungsform eines 1-lagigen Gehäuses 10' mit einem einzelnen Kanal 11', in welchem ein einzelner Kontaktstift 30' angeordnet ist.

Der Basiskörper 10' ist eine metallische Platte, in einer bevorzugten Ausführung eine Kupferplatte. An der Oberseite 10a des Basisköpers 10' ist der Montagebereich 14' für ein opto-elektronisches Funktionselement 40' definiert. Er wird hier durch eine ebene oder im Wesentlichen ebene Oberseite 10a' bereitgestellt.

Insbesondere um die Fertigungskosten möglicht gering halten zu können, ist der Basiskörper 10' mit dem eingebrachten Kanal 11' mittels eines Stanzverfahrens hergestellt. Der eingebrachte Kanal 11' weist hier einen ersten Abschnitt 11-1' und einen zweiten Abschnitt 11-2' auf.

Der erste Abschnitt 11-1' ist als eine nicht randseitige Aussparung 13', hier als ein Loch oder eine durchgehende Öffnung, in dem Basiskörper 10' ausgeführt. Der erste Abschnitt 11-1' des Kanals 11' erstreckt sich von der Oberseite 10a' des Basiskörpers 10' bis zur Rückseite 10b' des Basiskörpers 10'. Es wird eine Art Rohr in dem Basiskörper 10' gebildet. Der erste Abschnitt 11-1' verläuft hier im Wesentlichen parallel zu der Mittelachse 10d' des Basiskörpers 10'.

Der zweite Abschnitt 11-2' des Kanals 11' verläuft quer, hier senkrecht, zu dem ersten Abschnitt 11-1' des Kanals 11'. Zudem verläuft der zweite Abschnitt 11-2' auch quer, hier senkrecht, zu der Mittelachse 10d des Basiskörpers 10' .

Der zweite Abschnitt 11-2' ist als eine Aussparung in der Rückseite 10b' des Basiskörpers 10' ausgeführt. Diese erstreckt sich ausgehend von der Mittelachse 10d des Basiskörpers 10' in Richtung des Rands 10c' des Basiskörpers 10'. Es wird eine Art nach unten offener Kanal 11' in dem Basiskörper 10' gebildet. Der zweite Abschnitt 11-2' mündet in den Rand 10c' des Basiskörpers 10'.

In der vorliegenden Ausgestaltung wird der Kanal 10' durch den ersten Abschnitt 11-1' und den zweiten Abschnitt 11-2' gebildet. Dabei mündet der erste Abschnitt 11-1' des Kanals 11' in den zweiten Abschnitt 11-2' des Kanals 11'. Der Kanal 11' ist in einer Querschnittsdarstellung im Wesentlichen L-förmig (siehe dazu Figur 1.c').

Der Kanal 11' bzw. der erste 11-1' und der zweite Abschnitt 11-2' des Kanals 11' sind hier im Wesentlichen vollständig mit einem Glas 20' gefüllt. Es ist ein Glas 20' zum Verbinden von Basiskörper 10' und Anschlusskörper 30'. Das Glas 20' ist ein Alkali-Titan-Silikat-Glas. Der Kontaktstift 30' ist in dem Kanal 11' angeordnet und in das Glas 20' eingebettet.

In einem ersten Verfahrensschritt wird dazu zunächst der Basiskörper 10' mit dem eingebrachten Kanal 11' bzw. 11-1' und 11-2' bereitgestellt. In einer Ausgestaltung des Verfahrens wird der Kanal 11' bzw. 11-1' und 11-2' zunächst mit dem Glas 20', welches sich vorzugsweise in einem flüssigen oder niedrigviskosen Zustand befindet, befüllt. Dazu befindet sich das Glas 20' in einem entsprechend erwärmten Zustand. Für das vorliegende Glas 20' liegt dies bei einer Temperatur in einem Bereich von etwa 400°C bis etwa 1000°C, vorzugsweise 500°C bis etwa 700°C. Ein Beispiel zum Befüllen stellt das Dispensen dar. Nach dem Befüllen des Kanals 11' bzw. 11-1' und 11-2' wird der Kontaktstift 30' in den befüllten Kanal 11' bzw. 11-1' und 11-2' eingesteckt oder einpresst, hier über die Rückseite 10b des Basiskörpers 10'.

Der Kontaktstift 30' ist in seinen Abmessungen und seiner Form an die Abmessungen und die Form des Kanals 11' angepasst, in dem er eingebracht ist. In dem gezeigten Beispiel besitzt der Kontaktstift 30' ebenso eine im Wesentlichen L-förmige Form und somit ebenso einen ersten Abschnitt 30-1' und einen zweiten Abschnitt 30-2'. Der Kontaktstift 30' besitzt die Form eines Hakens.

Der erste Abschnitt 30-1' des Kontaktstifts 30' ist dem Bereich des ersten Abschnitts 11-1' des Kanals 11' zugeordnet. Der zweite Abschnitt 30-2' des Kontaktstifts 30' ist dem Bereich des zweiten Abschnitts 11-2' des Kanals 11' zugeordnet. Der erste Abschnitt 30-1' ist, mit Ausnahme seiner Stirnseite 30a', im Wesentlichen vollständig von dem Glas 20' umgeben. Diese freie Stirnseite 30a' schließt mit der Oberseite 10a' des Basiskörpers 10' ab. Sie stellt den Anschluss für das opto-elektronische Funktionselement 40' bereit. Die freie Stirnseite 30a' kann auch oberhalb der Oberseite 10a' liegen.

Dagegen ist der zweite Abschnitt 30-2' in dem gezeigten Beispiel nicht vollständig von dem Glas 20' umgeben. Denn zum einen schließt der zweite Abschnitt 30-2' nicht mit dem Rand 10c' des Basiskörpers 10' ab. Er erstreckt sich vielmehr über den Rand 10c' des Basiskörpers 10' hinaus. Dadurch kann der Kontaktstift 30' zum Beispiel entsprechend gebogen werden, um zu einem Verbindungselement zu gelangen. Dadurch liegt auch die Stirnseite 30b' des zweiten Abschnitts 30-2' frei. Zum anderen ist der zweite Abschnitt 30-2' auch im Bereich des Basiskörpers 10' nicht vollständig in das Glas 20 eingetaucht. Die Rückseite der Mantelfläche 30c' des zweiten Abschnitts 30-2' liegt frei oberhalb des Glases 20'. Dadurch ist auch eine Rückseitenkontaktierung durch ein einfaches Aufsetzen auf eine Leiterbahn möglich (siehe dazu Figur 9.d').

Um Wiederholungen zu vermeiden, werden für die nachfolgend beschriebenen Ausführungsformen jeweils nur die Änderungen beschrieben. Für identische oder auch ähnliche Merkmale sei jeweils auf die vorab beschriebenen Ausführungsformen verwiesen.

Die Figuren 2.a' bis 2.c' zeigen eine zweite Ausführungsform der vorliegenden Erfindung. Als Änderung gegenüber der in den Figuren 1.a' bis 1.' gezeigten ersten erfindungsgemäßen Ausführungsform weist die Oberseite 10a' des Basiskörpers 10' nun eine Vertiefung 15' auf, beispielsweise bereitgestellt durch eine Aussparung 15'. Das Funktionselement 40 kann nun geschützt in der Vertiefung 15' liegen. Die Vertiefung 15' besitzt hier einen runden, vorzugsweise kreisförmigen Querschnitt. Das Funktionselement 40' ist auf dem Boden der Vertiefung 15' und insbesondere im Zentrum der Vertiefung 15' angeordnet. Der Durchmesser der Vertiefung 15' vergrößert sich, vorzugsweise kontinuierlich, ausgehend von dem Boden der Vertiefung 15' zu seiner Oberseite. Die Vertiefung 15' besitzt die Gestalt eines Kegelstumpfs.

Ist das Funktionselement 40 zum Beispiel als LED 40' ausgeführt, so kann die Innenseite oder der Mantel der Vertiefung 15' zur Verbesserung der Beleuchtung, insbesondere zumindest abschnittsweise, reflektierende Eigenschaften besitzen. Die Vertiefung 15' kann somit auch als Reflektor 15' bezeichnet werden. In Abhängigkeit von dem Material und/oder der Art ihrer Herstellung kann die Vertiefung 15' oder die Innenseite der Vertiefung 15' bereits ausreichend hohe reflektierende Eigenschaften besitzen. Im Allgemeinen wird jedoch eine Nachbearbeitung der Innenseite oder des Mantels der Vertiefung 15' erforderlich sein. Die reflektierenden Eigenschaften können zum einen durch ein entsprechendes Bearbeiten der Innenseite, beispielsweise durch Polieren, erreicht werden. Als Alternative oder als Ergänzung kann die Innenseite auch noch abschnittsweise oder vollständig beschichtet und/oder verkleidet sein, vorzugsweise mit einem Metall. Das Material, vorzugsweise das Metall, zur Herstellung der Beschichtung und/oder der Verkleidung ist wenigstens ein Material, das ausgewählt ist aus einer Gruppe bestehend aus Silber, Aluminium, Nickel, Palladium und Gold. Das Verfahren zum Erzeugen oder Herstellen der Beschichtung ist wenigstens ein Verfahren, das ausgewählt ist aus einer Gruppe bestehend aus Galvanisieren und Verdampfen, insbesondere PVD und/oder CVD.

Die Figuren 3.a' bis 3.c' zeigen eine dritte Ausführungsform der Erfindung. Als Änderung zu der in den Figuren 2.a' bis 2.c' gezeigten Ausführungsform besitzt die Vertiefung 15' nun einen eckigen Querschnitt. Es ist eine Vertiefung 15' mit einem rechteckigen, vorzugsweise quadratischen, Querschnitt dargestellt. Die Vertiefung 15' besitzt die Gestalt eines Pyramidenstumpfs.

Weiterhin illustrieren die Figuren 4.a' bis 4.c' eine vierte Ausführungsform eines 1-lagigen Gehäuses 10'. Als Änderung ist der Basiskörper 10' nun nicht mehr "nur" rechteckig, sondern quadratisch ausgebildet. Die Vertiefung 15' ist konzentrisch im Basiskörper 10' oder koaxial zur Mittelachse 10d' des Basiskörpers 10' angeordnet. Der Kontaktstift 30' ist nun zudem nicht mehr als Haken sondern als gerader oder nadelartiger Stift ausgeführt. Er wird nur durch einen ersten, hier geraden Abschnitt 30-1' gebildet. Es ist ein Kontaktstift 30' mit einem einzelnen Schenkel 30-1 ohne einen quer dazu verlaufenden Schenkel 30-2'. Zudem ist der Kontaktstift 30' auch nicht mehr im Bereich der Außenseite des Basiskörpers 10' angeordnet. Er ist nun im Bereich des Mantels der Vertiefung 15' angeordnet. Dazu ist der Kanal 11' im Mantel der Vertiefung 15' vorgesehen. Der Kanal 11' mündet in den Mantel der Vertiefung 15'. Der Kanal 11' verbindet die Vorderseite 10a' des Basiskörpers 10' mit seiner Rückseite 10b'. Der Kanal 11' verläuft in dem dargestellten Beispiel senkrecht zu der Rückseite 10b' des Basiskörpers 10' oder parallel zur Mittelachse 10d' des Basiskörpers 10'. Durch diese Positionierung des Kanals 11' wird eine räumliche Nähe des Kontaktstiftes 30 zu dem Funktionselement 40' gewährt. Beispielsweise ist ein Führen eines Drahtes 50' entlang der Oberseite 10a' des Basiskörpers 10' nicht mehr erforderlich.

Der Kontaktstift 30' ist im Inneren des Kanals 11' oder 11-1' angeordnet. Er ist im Wesentlichen im Zentrum des Kanals 11-1' angeordnet. Er ist mittels einer Glasschicht 20' an oder in dem Basisköper 10' oder an bzw. in dem Kanal 11' befestigt. Der Kanal 11' ist nur insoweit mit dem Glas 20' zum Bereitstellen der verbindenden Glasschicht 20' befüllt, dass der Innenraum des Kanals 11-1' oberhalb des Bodens der Vertiefung 15 im Wesentlichen frei von Glas 20' ist. Dadurch kann ein Fließen des Glases 20' in die Vertiefung 15' hinein vermieden werden.

Zusätzlich ist in der Oberseite 10a' des Basiskörpers 10' noch ein Aufnahmebereich 16' für ein optisches Bauelement 60' vorgesehen. Das optische Bauelement 60' ist zum Beispiel eine Linse 60', insbesondere eine Glaslinse 60'. Der Aufnahmebereich 16' ist als eine weitere Vertiefung in der Oberseite 10a' des Basiskörpers 10' ausgebildet. Diese weitere Vertiefung besitzt einen gegenüber der Oberseite des Reflektors 15' vergrößerten Querschnitt und eine beispielhafte Tiefe von etwa 0,1 bis 1 mm.

Zusammenfassend sind in den vorab beschriebenen Figuren 1.a' bis 4.c' jeweils Ausgestaltungen der Erfindung mit nur einem einzelnen Kontaktstift 30' und einer einzelnen Vertiefung 15' im Basisköper 10' dargestellt. Dagegen zeigen die in den Figuren 5.a' bis 8' dargestellten und nachfolgend erläuterten Ausführungsformen der Erfindung einen Basiskörper 10' mit einer Vielzahl an Kontaktstiften 30 und zum Teil zusätzlich auch mit einer Vielzahl an Vertiefungen bzw. Reflektoren 15'.

Zunächst illustrieren die Figuren 5.a' bis 5.d' eine erste Ausführungsform ohne Vertiefung bzw. ohne Reflektor 15'. Ein einzelnes Funktionselement 40' oder aber eine Vielzahl von Funktionselementen 40' kann auf der Oberseite 10a' des Basiskörpers 10' angeordnet sein. Da jedoch eine Vielzahl von Kanälen 11' und Kontaktstiften 30' vorgesehen ist, wird im Allgemeinen eine Vielzahl von Funktionselementen 40' auf der Oberseite 10a' angeordnet sein.

Der Basiskörper 10' ist im Wesentlichen rund, vorzugsweise kreisförmig. Der Kreis wird durch ein Vieleck gebildet oder angenähert. Der Rand 10c' bzw. die Kontur des Basiskörpers 10' wird in der dargestellten Version nicht durch eine gekrümmte Kurve sondern durch ein 12-Eck gebildet (siehe Figur 5.a').

Die Kanäle 11' und die Kontaktstifte 30' sind über den Umfang des Montagebereichs 14' verteilt angeordnet. Sie sind nicht am Rand 10c' bzw. der Kante des Basiskörpers 10' angeordnet. Sie sind nach innen, d.h. zum Zentrum des Basiskörpers 10' hin verschoben angeordnet. Sie sind über den Umfang eines Kreises in dem Basiskörper 10' angeordnet. Vorzugsweise sind sie über den Kreisumfang äquidistant zueinander angeordnet. In dem gezeigten Beispiel sind zwölf Kanäle 11' und zwölf Kontaktstifte 30' in dem Basiskörper 10' eingebracht.

Die Kanäle 11' und die Kontaktstifte 30' besitzen, wie schon in den Figuren 4.a' bis 4.c' gezeigt, wiederum nur einen ersten, hier geraden, Abschnitt 11-1' und 30-1'. Für jeden Kontaktstift 30' ist jeweils ein Kanal 11', der als Öffnung in dem Basiskörper 10' ausgeführt ist, vorgesehen. Ein Kontaktstift 30' ist einem Kanal 11' zugeordnet. Der Kanal 11' verbindet die Vorderseite 10a' mit der Rückseite 10b des Basiskörpers 10'. Der Kanal 11' ist mit dem Glas zur Bildung der Glasschicht 20' gefüllt. Im Inneren des Glases 20' und vorzugsweise im Zentrum des Kanals 11' ist der Kontaktstift 30' angeordnet. Der Kontaktstift 30' ist von dem Basiskörper 10' durch die Glasschicht 20' elektrisch isoliert. Im einfachsten Fall kann ein Kontaktstift 30' in einen mit Glas 20' befüllten Kanal 11' eingesteckt werden. Zum Beispiel kann ein Funktionselement 40' mit einer Unterseitenkontaktierung zum Anschließen auf den Kanal 11' und die dort freiliegende Stirnseite 30a' des Kontaktstifts 30' aufgesetzt werden (siehe dazu Figur 9.d'). Die Kanäle 11' sind nicht randseitig angeordnete Kanäle 13'.

Die Figuren 6.a' bis 6.e' illustrieren eine zweite Variante eines 1-lagigen Gehäuses 10' mit mehreren Kanälen 11' und mehreren Kontaktstiften 30'. Im Unterschied zu der in den Figuren 5.a' bis 5.c' dargestellten ersten Variante besitzen sowohl die Kanäle 11' als auch die Kontaktstifte 30' wiederum eine Hakenform oder L-Form. Ein erster Abschnitt 30-1' oder Schenkel des Hakens verläuft im Wesentlichen parallel zur Mittelachse 10d' des Basiskörpers 10'. Ein zweiter Abschnitt 30-2' oder Schenkel des Hakens steht im Wesentlichen quer, hier senkrecht, zu dem ersten Abschnitt 30-1' des Hakens. Dieser zweite Abschnitt 30-2' erstreckt sich radial nach außen. Die Kanäle 11' und die Kontaktstifte 30' sind im Wesentlichen entsprechend der in den Figuren 1.a' bis 1.c' gezeigten Ausführungsform in bzw. an dem Basiskörper 10' ein- bzw. angebracht. Die Vielzahl der Kanäle 11' und der Kontaktstifte 30' sind über den Umfang des Basiskörpers 10' verteilt angeordnet.

Im Unterschied dazu erstrecken sich die Kontaktstifte 30' mit dem zweiten Abschnitt 30-' nicht über den Rand 10c' des Basiskörpers 10' hinaus. Sie schließen mit dem Rand 10c' des Basiskörpers 10' ab. Zudem sind nicht alle Kanäle 11' und Kontaktstifte 30' gleich lang. In dem gezeigten Beispiel sind sechs kurze Kanäle 11' und sechs kurze Kontaktstifte 30' sowie ein langer Kanal 11' und ein langer Kontaktstift 30' an oder in dem Basiskörper 10' angeordnet.

Die kurzen Kontaktstifte 30' bzw. die Kontaktstifte 30' mit dem kurzen zweiten Abschnitt 30-2', sind entlang des Umfangs des Basiskörpers 10' im Wesentlichen äquidistant zueinander angeordnet. Der lange Kontaktstift 30' besitzt dagegen einen verlängerten zweiten Abschnitt 30-2'. Er mündet mit seinem ersten Abschnitt 30-1' im Zentrum oder auf der Mittelachse 10d' in die Oberseite 10a' des Basiskörpers 10'.

Zum Beispiel kann diese Anordnung zum Steuern von sechs auf dem Montagebereich angeordneten LEDs 40' verwendet werden. Die sechs LEDs 40' besitzen einen gemeinsamen Anschluss, zum Beispiel den zentralen Kontaktstift 30', als Anode oder Kathode. Sie besitzen aber jeweils einen eigenen Anschluss, zum Beispiel die sechs über den Umfang verteilten kurzen Kontaktstifte 30', als Kathode bzw. Anode, so dass die sechs LEDs 40' separat ein- und ausschaltbar sind.

Die Figuren 7.a' bis 7.e' zeigen eine dritte Ausführungsform eines 1-lagigen Gehäuses 10' mit mehreren Kanälen 11' und mehreren Kontaktstiften 30'. Der Basiskörper 10' weist eine Vielzahl von Reflektoren 15', hier von beispielhaft sechs Reflektoren 15', auf. Sie sind um die Mittelachse 10d' des Basiskörpers 10' herum angeordnet. Weiterhin weist der Basiskörper 10' zwölf Kanäle 11' und zwölf Kontaktstifte 30' auf. Diese entsprechen im Wesentlichen den in den Figuren 6.a' bis 6.e' gezeigten kurzen Kanälen 11' und kurzen Kontaktstiften 30'. Im Unterschied dazu sind sie hier jedoch paarweise angeordnet. Ein Paar aus zwei Kanälen 11' mit zwei Kontaktstiften 30' ist dabei jeweils einem Reflektor 15' zugeordnet. Durch diese zwei Anschlüsse pro Reflektor 15' können jeweils eine Anode und eine Kathode einem Reflektor 15' oder einem oder einer Vielzahl von in dem Reflektor 15' positionierten Funktionselement(en) 40' zugeordnet werden.

Die Figuren 8.a' und 8.b' illustrieren eine vierte Ausführungsform eines 1-lagigen Gehäuses 10' mit mehreren Kanälen 11' und mehreren Kontaktstiften 30'. Beispielhaft haben die Kontaktstifte 30' hier keinen runden oder kreisförmigen Querschnitt sondern einen eckigen, hier rechteckigen, Querschnitt.

Die Kanäle 11', und die Kontaktstifte 30' sind über den Umfang des Basiskörpers 10' verteilt, vorzugsweise im Wesentlichen äquidistant zueinander, angeordnet. Die Kanäle 11' und die Kontaktstifte 30' werden nur durch einen geraden ersten Abschnitt 11-1' bzw. 30-1' gebildet. Sie sind jeweils im Wesentlichen I-förmig. Im Gegensatz zu den vorstehend gezeigten Varianten sind die Kanäle 11' bzw. deren erste Abschnitte 11-1' hier nicht im Inneren des Basiskörpers 10' (nicht randseitig) sondern randseitig am Basiskörper 10' angeordnet. Es sind randseitig angeordnete Kanäle 12'. Die Oberfläche 30c' der Kontaktstifte 30', die nach außen zeigt, liegt hier frei.

Figur 8.b' zeigt die gleiche Ausgestaltung wie in Figur 8.a'. Zusätzlich ist jedoch an dem Rand 10c' des Basiskörpers 10' noch eine Hülse 36' positioniert. Vorzugsweise ist die Hülse 36' eine metallische Hülse, wie zum Beispiel aus Edelstahl. Dadurch ist es möglich, die Außenseite des Gehäuses 100' potentialfrei bereitzustellen. Es wird ein potentialfreier Außenleiter gebildet oder eine Abschirmung bereitgestellt.

Im Querschnitt ist zu erkennen, dass eine Art Ring-in-RingSystem um den Basiskörper 10' herum gebildet wird. Dabei stellt eine verbindende Glasschicht 35' einen ersten Ring und die Hülse 36' einen zweiten Ring dar. Sie sind zusammen um den Basiskörper 10' herum angeordnet. Die Glasschicht 35' und die Hülse 36' erstrecken sich hier vollständig und/oder kontinuierlich über den Umfang des Basiskörpers 10'. Der Querschnitt des Basiskörpers 10' bzw. des Gehäuses 100' ist hier beispielhaft eckig dargestellt. Der Querschnitt kann aber auch rund sein.

In einem ersten Fazit sind in den vorstehend beschriebenen Figuren 1.a' bis 8.b' erfindungsgemäße Ausgestaltungen gezeigt, bei denen nur das Gehäuse 10', hier bereitgestellt durch den Basiskörper 10', ohne ein darauf oder darin positioniertes Funktionselement 40', dargestellt.

Dagegen zeigen die nachfolgend beschriebenen Figuren 9.a' bis 10.f' verschiedene Varianten, wie ein Funktionselement 40' (Figuren 9.a' bis 9.d') oder aber eine Vielzahl von Funktionselementen 40' (Figuren 10.a' bis 10.f') kontaktiert werden kann.

Das Funktionselement 40' ist nach dem Einbau in das Gehäuse 10' oder dem Aufsetzen auf den Basiskörper 10' in direktem Kontakt mit dem Basiskörper 10'. Die Oberseite 10a' des Basiskörpers 10' oder des Reflektors 15' ist im Allgemeinen im Wesentlichen eben. Das Funktionselement 40' kann zum Beispiel auf den Basiskörper 10' aufgeklebt oder aufgelötet werden. Als Lote werden vorzugsweise bleifreie Weichlote verwendet. Der Kleber ist vorzugsweise ein leitfähiger Kleber, wie ein mit Silber angereicherter Epoxidharz. Somit wird über einen direkten Kontakt auch ein Kontakt über einen Kleber, Lot oder ein Bindemittel verstanden.

Die gewählte Form der Kontaktstifte 30' entspricht hier beispielhaft dem in den Figuren 5.a' bis 5.d' dargestellten Kontaktstift 30'.

Zunächst zeigen die Figuren 9.a' bis 9.f' einige Verwendungen eines erfindungsgemäßen Gehäuses 10' mit einem einzelnen auf dem Basiskörper 10' oder in dem Gehäuse 10' positionierten Funktionselement 40'.

Figur 9.a' zeigt ein Gehäuse 10' bzw. einen Basiskörper 10' mit einem einzelnen Kanal 11' und einem darin eingebrachten einzelnen Kontaktstift 30'. Das Funktionselement 40', wie zum Beispiel eine LED, ist hier mittels zweier Kontakte, nämlich Anode und Kathode, über seine Vorderseite kontaktierbar. Das Funktionselement 40' wird über einen Draht 50 (sogenanntes Wire- oder Draht-Bonding) mit den Zuleitungen bzw. Anschlüssen des Gehäuses 10' verbunden. Ein erster Anschluss wird durch den Kontaktstift 30' bereitgestellt. Ein zweiter Anschluss wird durch den Basiskörper 10' selbst, hier einen metallischen Basiskörper 10', bereitgestellt.

Figur 9.b zeigt die in Figur 9.a' dargestellte Ausgestaltung mit einer auf dem Basiskörper 10' aufgebrachten Linse 60' als Abschlusselement. Die Linse 60' wird zum Beispiel durch ein Applizieren eines Tropfens eines für den Emissionsbereich der LED transparenten Materials, wie zum Beispiel Silikon, bereitgestellt.

Figur 9.c' zeigt eine Ausführungsform eines Gehäuses 10' mit einer auf dem Basiskörper 10' aufgebrachten Linse 60' als Abschlusselement. Die Linse 60' wird zum Beispiel durch eine Glaslinse bereitgestellt. Diese ist mittels einer Halterung 61' beabstandet von der Oberseite 10a' an dem Basiskörper 10' befestigt. Die Halterung 61' kann zum Beispiel durch eine Art Bügel oder einen rohrförmigen Abschnitt bereitgestellt werden. Das hier dargestellte Funktionselement 40' ist über seine Vorderseite und seine Rückseite anschließbar. Ein erster Anschluss wird durch einen seitlich angebrachten Kontaktstift 30' gebildet. Ein zweiter Anschluss wird durch den Basiskörper 10' selbst bereitgestellt. Zusätzlich ist an dem Rand 10c' des Basiskörpers 10' noch eine Hülse 36' positioniert. Der Basiskörper 10' ist von der Hülse 34', die mittels der Glasschicht 35' am Basiskörper 10' befestigt ist, umgeben. Für weitere Details sei auf die Ausführungen zu Figur 8.b' verwiesen.

Figur 9.d' zeigt eine Ausführungsform eines Gehäuses 10' mit mehreren, hier zwei, Kontaktstiften 30' in dem Basiskörper 10'. Die Anschlüsse werden durch die zwei Kontaktstifte 30' bereitgestellt.

Als Erweiterung gegenüber Figur 9.d' zeigt Figur 9.e' eine Ausführungsform eines Gehäuses 10', in welchem auf der Unterseite 10b' des Basiskörpers 10' noch eine Isolation 17', insbesondere eine isolierende Schicht 17', aufgebracht ist. Die Isolation 17' ist segmentiert ausgeführt. Die Unterseite 10b' des Basiskörper 10' ist, mit Ausnahme der beiden Kanäle 11', vollständig oder im Wesentlichen vollständig mit der Isolation 15' bedeckt. Dadurch kann die Unterseite 10b' des Gehäuses 10' potentialfrei bereitgestellt werden. Diese Ausgestaltung ist insbesondere dann geeignet, wenn der Basiskörper 10' als ein Anschluss für das Funktionselement 40' verwendet wird und somit ein Spannungsführendes Bauteil darstellt.

Ist eine ausreichende Anzahl an Anschlusskörpern 30 zum Ansteuern eines Funktionselements 40' oder einer Vielzahl von Funktionselementen 40' vorhanden, so kann die Unterseite 10b' des Basiskörpers 10' auch potentialfrei bereitgestellt werden, indem der Basiskörper 10' ausschließlich als Träger und die Anschlusskörper zum Bereitstellen der Anschlüsse verwendet werden. Dies ist beispielsweise bei den in den Figuren 5.a' bis 8.a' dargestellten Gehäusen 10' zutreffend.

Während die Figuren 9.a' bis 9.e' eine Ausgestaltung eines Funktionselements 40' illustrieren, das ausschließlich über seine Vorderseite kontaktierbar ist, zeigt Figur 9.f' eine Ausgestaltung, bei der das Funktionselement 40' über seine Vorderseite und seine Rückseite kontaktierbar ist.

Die in Figur 9.f' dargestellte Ausführungsform entspricht zum Teil der in Figur 9.a' dargestellten Ausführungsform. Ein erster Anschluss wird durch einen seitlich angebrachten Kontaktstift 30' bereitgestellt. Ein zweiter Anschluss wird durch einen vorzugsweise zentral angebrachten Kontaktstift 30 bereitgestellt. Das Funktionselement 40' wird mit seiner Unterseite auf die erste Stirnseite 30a' des Kontaktstifts 30' aufgesetzt und darüber kontaktiert.

Abschließend illustrieren die Figuren 10.a' bis 10.f' einige sogenannte Multi-Chip-Anwendungen mit einer Vielzahl von auf dem Basiskörper 10' positionierten Funktionselementen 40'. Aus Gründen einer besseren Übersicht sind beispielhaft nur zwei Funktionselemente 40' in den Figuren dargestellt.

Zunächst zeigt Figur 10.a' eine Ausführungsform, in der in einem Reflektor 15' zwei Funktionselemente 40' angeordnet sind. Dem Reflektor 15' sind hier zwei Kontaktstifte 30' zugeordnet. Die zwei Kontaktstifte 30' stellen für die zwei Funktionselemente 40' zwei gemeinsame Anschlüsse bereit. Beispielsweise teilen sich die zwei Funktionselemente 40' eine Anode und eine Kathode. Eine Kontaktstift 30' stellt die gemeinsame Kathode und der andere Kontaktstift 30' die gemeinsame Anode bereit.

Figur 10.b' zeigt eine Ausführungsform, die teilweise der in den Figuren 7.a' bis 7.d' gezeigten Ausgestaltung entspricht. Jedem der Funktionselemente 40' sind hier zwei Kontaktstifte 30' zugeordnet. Jedes Funktionselement 40' hat eine eigene bzw. separate Anode und eine eigene bzw. separate Kathode. Es sind auch Mischungen möglich, bei denen zum Beispiel jedem Funktionselement 40' jeweils ein Kontaktstift 30' zugeordnet ist und ein einzelner Kontaktstift 30' allen Funktionselementen 40' zugeordnet ist. In dieser Variante können sich die Funktionselemente 40' zum Beispiel eine gemeinsame Anode oder Kathode teilen, während jedem einzelnen Funktionselement 40' die individuelle Kathode bzw. Anode bereitgestellt wird. In beiden Varianten können die einzelnen Funktionselemente 40' unabhängig voneinander gesteuert werden.

Figur 10.c' zeigt eine Ausgestaltung der Erfindung, bei der pro Kanal 11' eine Vielzahl von Kontaktstiften 30' vorgesehen sind. Mehrere, hier zwei, Kontaktstifte 30' teilen sich einen Kanal 11'. Die Kontaktstifte 30' sind dabei derart in dem Glas 20' im Inneren des Kanals 11' eingebettet, dass sie sowohl zueinander als auch zu dem Basiskörper 10' keinen Kontakt haben und elektrisch isoliert sind. Eine solche Ausgestaltung zeichnet sich durch eine hohe Packungsdichte aus.

Figur 10.d' illustriert eine Ausgestaltung, in welcher eine Platte, zum Beispiel eine Glasplatte, als Abschlusselement 60' oder Deckel 60' auf dem Gehäuse 10' aufgebracht ist. Die durch die Platte heruntergedrückte Drähte 50' sind nur teilweise in der Figur eingezeichnet. Die Platte kann zum Beispiel mittels Klemmen und/oder Kleben und/oder Löten befestigt sein. Ebenso kann als Abschlusselement 60' auch eine Glaslinse 60' auf das Gehäuse 10' aufgesetzt werden. Schließlich zeigen die Figuren 10.' und 10.f' eine Version der Erfindung, in der eine Vielzahl von Reflektoren 15' in dem Basiskörper 10' vorhanden ist. Es wird jeweils ein Funktionselement 40' in einem Reflektor 15' angeordnet. Als Beispiel sind zwei Reflektoren 15' und Funktionselemente 40' dargestellt. In Figur 10.e' werden die Funktionselemente 40' wiederum durch eine gemeinsame Anode und eine gemeinsame Kathode versorgt. In Figur 10.f' sind dagegen wieder jedem Funktionselement 40' eine separate Anode und eine separate Kathode zugeordnet. Als eine Besonderheit sind hier zwei unterschiedliche Arten zur Befestigung der Kontaktstifte 30' an dem Basiskörper 10' vorgesehen. Die zwei innen liegenden Kontaktstifte 30' sind entsprechend der in den Figuren 5.a' bis 5.d' dargestellten Kontaktstifte 30' angebracht. Die zwei äußeren Kontaktstifte 30' sind entsprechend der in der Figur 8' dargestellten Kontaktstifte 30' angebracht.

Es ist dem Fachmann ersichtlich, dass die beschriebenen Ausführungsformen beispielhaft zu verstehen sind. Die Erfindung ist nicht auf diese beschränkt sondern kann in vielfältiger Weise innerhalb des Schutzumfangs anhängigen Ansprüche variiert werden. Merkmale einzelner Ausführungsformen und die im allgemeinen Teil der Beschreibung genannten Merkmale können jeweils untereinander als auch miteinander kombiniert werden.

### Bezugszeichenliste:

- 10: Basiskörper
- 10a: Oberseite des Basiskörpers
- 10b: Unterseite des Basiskörpers
- 13: Mantel oder Rand des Basiskörpers
- 14: Montagebereich für ein Funktionselement
- 15: Isolation oder isolierende Schicht
- 16: Hülse oder Hülle

- 20: Glasschicht oder Glas zum Verbinden und Isolieren
- 23: Isolation oder weitere Glasschicht

- 30: Anschlusskörper

- 40: Funktionselement oder LED oder FET

- 50: Verbindungsmittel oder Draht oder Bonddraht

- 60: Abschlusselement oder optisches Bauelement oder Linse
- 61: Halterung für das Abschlusselement

- 70: Kopfteil
- 71: Öffnung im Kopfteil

- 100: Gehäuse

- 10': Basiskörper oder Gehäuse mit eingebrachtem Kanal und montiertem Anschlusskörper
- 10a': Oberseite des Basiskörpers
- 10b': Unterseite des Basiskörpers
- 10c': Rand des Basiskörpers
- 10d': Mittelachse oder Zentralachse des Basiskörpers

- 11': Kanal im oder am Basiskörper
- 11-1': Erster Abschnitt oder Schenkel des Kanals
- 11-2': Zweiter Abschnitt oder Schenkel des Kanals

- 12': randseitiger Kanal oder Kanalabschnitt am Basiskörper oder randseitige Aussparung am Basiskörper
- 13': nicht randseitiger Kanal oder Kanalabschnitt im Basiskörper oder nicht randseitige Aussparung im Basiskörper
- 14': Montagebereich für das Funktionselement
- 15': Vertiefung oder Reflektor im Basiskörper
- 16': Aufnahmebereich für ein Abschlusselement
- 17': Isolation oder isolierende Schicht

- 20': Glas oder Glasschicht zum Verbinden und Isolieren

- 30': Anschlusskörper oder Kontaktstift
- 30a': Erste Stirnseite des Anschlusskörpers
- 30b': Zweite Stirnseite des Anschlusskörpers
- 30c': Mantel des Anschlusskörpers

- 30-1': Erster Abschnitt des Anschlusskörpers
- 30-2': Zweiter Abschnitt des Anschlusskörpers

- 35': Isolation oder Glasschicht
- 36': Hülse oder Hülle

- 40': Opto-elektronisches Funktionselement oder LED
- 50': Bonding-Draht oder Draht
- 60': Abschlusselement oder Linse oder Glaslinse
- 61': Halterung für das Abschlusselement

## Patentansprüche

1. Gehäuse (100) zur Aufnahme eines elektronischen Funktionselements (40), welches unter Verwendung eines Alkali-Titan-Silikat-Glases aufgebaut ist und wobei Bauteile des Gehäuses (100) durch das Alkali-Titan-Silikat-Glas verbunden sind,
welches **dadurch gekennzeichnet ist, dass** das Alkali-Titan-Silikat-Glas die folgende Zusammensetzung (in Gew.%) umfasst:
| | |
|---|---|
| SiO₂ | 20-50 |
| TiO₂ | 10-35 |
| R₂O | 10-40 |
| | |
| | |
| | |
| Al₂O₃ | 0-5 |
| | |
| | |
| CaO+SrO | 0-5 |
| P₂O₅ | 0-5 |
| V₂O₅ | 0-5 |
| B₂O₃ | 0-5 |
| | |
| Sb₂O₃ | 0-1 |
| SnO₂ | 0-5 |
| Fe₂O₃ | < 1 |
| CoO | < 1 |
| NiO | < 1 |
| ZnO | 0-4 |
| ZrO₂ | 0-4 |
| F | 0-2 |
| MoO₃ | 0-1 |
| N₂O₅ | 0-6 |
| | |
| SO₃ | 0-1 |

2. Gehäuse (100) nach Anspruch 1, umfassend einen Basiskörper (10) und einen Anschlusskörper (30), wobei der Basiskörper (10) und der Anschlusskörper (30) ein Metall umfassen.

3. Gehäuse nach Anspruch 2, wobei der Basiskörper (10) wenigstens einen Kanal (11') aufweist, in welchem der wenigstens eine Anschlusskörper (30) zumindest abschnittsweise angeordnet ist und welcher zumindest abschnittsweise mit dem Alkali-Titan-Silikat-Glas zum Verbinden des Basiskörpers mit dem Anschlusskörper befüllt ist.

4. Gehäuse nach Anspruch 2 oder 3, wobei der wenigstens eine Kanal (11') in die Oberseite und/oder in die Unterseite und/oder in den Rand des Basiskörpers (10) mündet und ein durchgehende Verbindung zwischen der Oberseite und/oder der Unterseite und/oder dem Rand des Basiskörpers erzeugt.

5. Gehäuse nach einem der Ansprüche 2 bis 4, wobei sich der Kanal (11') von einer Vorderseite des Basiskörpers (10) in Richtung einer Rückseite erstreckt und als ein Loch ausgebildet ist.

6. Gehäuse (100) nach einem der Ansprüche 3 bis 5, wobei das Metall einen thermischen Längenausdehnungskoeffizienten α zwischen 13 und 25 * 10⁻⁶ K⁻¹ aufweist.

7. Gehäuse (100) nach einem der Ansprüche 2 bis 6, wobei der Basiskörper (10) und der Anschlusskörper (30), insbesondere in den Grenzflächen zu dem Glas (20), Kupfer und/oder eine Kupferlegierung und/oder Aluminium und/oder austenitischer Stahl und/oder austenitischer Edelstahl umfassen.

8. Gehäuse (100) nach einem der vorstehenden Ansprüche, wobei das Alkali-Titan-Silikat-Glas die folgende Zusammensetzung (in Gew.%) umfasst:
| | |
|---|---|
| SiO₂ | 26 - 30 |
| TiO₂ | 21 - 25 |
| | |
| Na₂O | 14 - 18 |
| K₂O | 11 - 15 |
| Li₂O | > 0 - 3 |
| Al₂O₃ | > 1 - 5 |
| CaO | > 0 - 1 |
| SrO | 0 - 1 |
| | |
| P₂O₅ | > 0 - 3 |
| B₂O₃ | > 0 - 4 |
| | |
| | |
| | |
| Fe₂O₃ | > 0 - 2 |
| CoO | 0 - 1 |
| NiO | 0 - 1 |
| | |
| | |
| | |
| ZnO | > 0 - 2 |
| ZrO₂ | > 0,5 -2 |
vorzugsweise:
| | |
|---|---|
| SiO₂ | 28 |
| TiO₂ | 23 |
| | |
| Na₂O | 16 |
| K₂O | 13 |
| Li₂O | 1,12 |
| Al₂O₃ | 3,4 |
| CaO | 0,2 |
| SrO | 0,02 |
| | |
| P₂O₅ | 1, 6 |
| | |
| B₂O₃ | 2 |
| | |
| Fe₂O₃ | 0,2 |
| CoO | 0,03 |
| NiO | <0,02 |
| | |
| | |
| | |
| ZnO | 0,2 |
| ZrO₂ | 0,9 |

9. Gehäuse (100) nach einem der vorstehenden Ansprüche, wobei das Alkali-Titan-Silikat-Glas die folgende Zusammensetzung (in Gew.%) umfasst:
| | |
|---|---|
| SiO₂ | 36 - 40 |
| TiO₂ | 24 - 28 |
| | |
| Na₂O | 15 - 19 |
| K₂O | 10 - 14 |
| Li₂O | > 0 - 3 |
| Al₂O₃ | 1 - 6 |
| CaO | > 0 - 1 |
| SrO | < 1 |
| | |
| P₂O₅ | > 0 - 4 |
| | |
| B₂O₃ | > 0 - 2 |
| | |
| Fe₂O₃ | 0 - 2 |
| CoO | < 1 |
| NiO | < 1 |
| | |
| | |
| | |
| ZnO | < 1 |
| ZrO₂ | < 1 |
vorzugsweise:
| | |
|---|---|
| SiO₂ | 38 |
| TiO₂ | 26 |
| | |
| Na₂O | 17 |
| K₂O | 11,6 |
| Li₂O | 1,22 |
| Al₂O₃ | 3,7 |
| CaO | 0,3 |
| | |
| | |
| P₂O₅ | 1, 6 |
| | |
| B₂O₃ | 0,29 |
| | |
| | |
| | |
| Fe₂O₃ | 0,08 |
| | |
| NiO | <0,02 |
| | |
| | |
| ZrO₂ | 0,1 |

10. Gehäuse (100) nach einem der vorstehenden Ansprüche 2 bis 9, **dadurch gekennzeichnet, dass**
die Glasschicht (20) zumindest abschnittsweise zwischen dem Mantel (13) des Basiskörpers (10) und dem Anschlusskörper (30) und/oder
zwischen der Oberseite (10a) des Basiskörpers (10) und dem Anschlusskörper (30) angeordnet ist
zwischen der Unterseite (10b) des Basiskörpers (10) und dem Anschlusskörper (30) angeordnet ist.

11. Gehäuse (100) nach einem der Ansprüche 1 bis 10, wobei der Anschlusskörper (30) durch eine Glasschicht elektrisch vom Basiskörper (10) isoliert ist.

12. Gehäuse (100) nach einem der Ansprüche 2-11, wobei der Anschlusskörper ein Kontaktstift (30') ist, insbesondere wobei der Kontaktstift (30') ein im Wesentlichen gerader Stift oder zumindest abschnittsweise als Haken oder L-förmig ausgeführt ist.

13. Gehäuse (100) nach einem der vorstehenden Ansprüche, wobei das Glas eine Erweichungstemperatur in einem Bereich besitzt, welcher unterhalb der Schmelztemperatur der Materialien liegt, die für den Basiskörper und/oder den Anschlusskörper verwendet werden und/oder Gehäuse (100) nach einem der vorstehenden Ansprüche, wobei das Glas (20) eine Dicke besitzt, die in einem Bereich zwischen 30 µm und 2000 µm liegt.

14. Gehäuse nach mindestens nach Anspruch 12, wobei der elektrische Widerstand einer mit dem Alkali-Titan-Silikatglas gebildeten Glasschicht mehr als 1 GΩ beträgt.

15. Verwendung eines Alkali-Titan-Silikat-Glases zum Aufbau eines Gehäuses (100) zur Aufnahme eines elektronischen Funktionselements (40), insbesondere einer LED und/oder eines FETs, wobei Bauteile des Gehäuses (100) durch das Alkali-Titan-Silikat-Glas verbunden werden, welches **dadurch gekennzeichnet ist, dass** das Alkali-Titan-Silikat-Glas die folgende Zusammensetzung (in Gew.%) umfasst:
| | |
|---|---|
| SiO₂ | 20-50 |
| TiO₂ | 10-35 |
| R₂0 | 10-40 |
| | |
| | |
| | |
| Al₂O₃ | 0-5 |
| | |
| | |
| CaO+SrO | 0-5 |
| P₂O₅ | 0-5 |
| V₂O₅ | 0-5 |
| B₂O₃ | 0-5 |
| Sb₂O₃ | 0-1 |
| SnO₂ | 0-5 |
| Fe₂O₃ | < 1 |
| CoO | < 1 |
| NiO | < 1 |
| | |
| | |
| | |
| ZnO | 0-4 |
| ZrO₂ | 0-4 |
| F | 0-2 |
| M0O₃ | 0-1 |
| N₂O₅ | 0-6 |
| | |
| SO₃ | 0-1 |
.

## Claims

1. A housing (100) for accommodating an electronic functional element (40), which is made using an alkali titanium silicate glass and having components of the housing joined by said alkali titanium silicate glass;
**characterised in that** the alkali titanium silicate glass has the following composition (in wt%):
| | |
|---|---|
| SiO₂ | 20-50 |
| TiO₂ | 10-35 |
| R₂O | 10-40 |
| | |
| Al₂O₃ | 0-5 |
| | |
| CaO + SrO | 0-5 |
| P₂O₅ | 0-5 |
| V₂O₅ | 0-5 |
| B₂O₃ | 0-5 |
| | |
| Sb₂O₃ | 0-1 |
| SnO₂ | 0-5 |
| Fe₂O₃ | < 1 |
| CoO | < 1 |
| NiO | < 1 |
| | |
| ZnO | 0-4 |
| ZrO₂ | 0-4 |
| F | 0-2 |
| M0O₃ | 0-1 |
| N₂O₅ | 0-6 |
| | |
| SO₃ | 0-1. |

2. The housing (100) according to claim 1,
comprising a base body (10) and a connecting body (30), said base body (10) and said connecting body (30) comprising a metal.

3. The housing according to claim 2, wherein the base body (10) has at least one channel (11'), in which the at least one connecting body (30) is arranged, at least portions thereof, and which is at least partially filled with said alkali titanium silicate glass to join the base body to the connecting body,

4. The housing according to claim 2 or 3, wherein the at least one channel (11') opens to the upper surface and/or to the lower surface and/or to the lateral surface of the base body (10) and provides continuous communication between the upper surface and/or the lower surface and/or the lateral surface of the base body.

5. The housing according to any one of claims 2 to 4, wherein the channel (11') extends from a front face of the base body (10) towards a rear face and is in the form of a hole.

6. The housing (100) according to any one of claims 3 to 5, wherein the metal has a coefficient of mean linear thermal expansion α between 13 and 25 * 10⁻⁶ K⁻¹.

7. The housing (100) according to any one of claims 2 to 6, wherein the base body (10) and the connecting body (30) comprise copper and/or a copper alloy and/or aluminium and/or austenitic steel and/or austenitic stainless steel, in particular at the interfaces to the glass (20).

8. The housing (100) according to any one of the preceding claims, wherein the alkali titanium silicate glass has the following composition (in wt%):
| | |
|---|---|
| SiO₂ | 26 - 30 |
| TiO₂ | 21 - 25 |
| | |
| Na₂O | 14 - 18 |
| K₂O | 11 -15 |
| Li₂O | > 0 - 3 |
| Al₂O₃ | > 1 - 5 |
| CaO | > 0 - 1 |
| SrO | 0-1 |
| | |
| P₂O₅ | >0-3 |
| | |
| B₂O₃ | > 0 - 4 |
| | |
| Fe₂O₃ | > 0 - 2 |
| CoO | 0-1 |
| NiO | 0-1 |
| | |
| ZnO | > 0 - 2 |
| ZrO₂ | > 0.5 - 2 ; |
preferably:
| | |
|---|---|
| SiO₂ | 28 |
| TiO₂ | 23 |
| | |
| Na₂O | 16 |
| K₂O | 13 |
| Li₂O | 1.12 |
| Al₂O₃ | 3.4 |
| CaO | 0.2 |
| SrO | 0.02 |
| | |
| P₂O₅ | 1.6 |
| | |
| B₂O₃ | 2 |
| | |
| Fe₂O₃ | 0.2 |
| CoO | 0.03 |
| NiO | < 0.02 |
| | |
| ZnO | 0.2 |
| ZrO₂ | 0.9. |

9. The housing (100) according to any one of the preceding claims, wherein the alkali titanium silicate glass has the following composition (in wt%):
| | |
|---|---|
| SiO₂ | 36 - 40 |
| TiO₂ | 24 - 28 |
| | |
| Na₂O | 15 - 19 |
| K₂O | 10 - 14 |
| Li₂O | > 0 - 3 |
| Al₂O₃ | 1 - 6 |
| CaO | > 0 - 1 |
| SrO | < 1 |
| | |
| P₂O₅ | > 0 - 4 |
| | |
| B₂O₃ | > 0 - 2 |
| | |
| Fe₂O₃ | 0-2 |
| CoO | < 1 |
| NiO | < 1 |
| | |
| ZnO | < 1 |
| ZrO₂ | < 1 ; |
preferably:
| | |
|---|---|
| SiO₂ | 38 |
| TiO₂ | 26 |
| | |
| Na₂O | 17 |
| K₂O | 11.6 |
| Li₂O | 1.22 |
| Al₂O₃ | 3.7 |
| CaO | 0.3 |
| | |
| P₂O₅ | 1.6 |
| | |
| B₂O₃ | 0.29 |
| | |
| Fe₂O₃ | 0.08 |
| | |
| NiO | < 0.02 |
| | |
| ZrO₂ | 0.1. |

10. The housing (100) according to any one of claims 2 to 9, **characterised in that**
the glass layer (20) is disposed at least in sections between the lateral surface (13) of the base body (10) and the connecting body (30); and/or
is disposed between the upper surface (10a) of the base body (10) and the connecting body (30); and/or
is disposed between the lower surface (10b) of the base body (10) and the connecting body (30).

11. The housing (100) according to any one of claims 1 to 10, wherein the connecting body (30) is electrically insulated from the base body (10) by a glass layer.

12. The housing (100) according to any one of claims 2 to 11, wherein the connecting body is a contact pin (30'), wherein in particular the contact pin (30') is in the form of a substantially straight pin or a hook or is L-shaped.

13. The housing (100) according to any one of the preceding claims, wherein the glass has a softening temperature in a range below the melting temperature of the materials used for the base body and/or for the connecting body and/or for the housing (100) according to any of the preceding claims, wherein the glass (20) has a thickness in a range between 30 µm and 2000 µm.

14. The housing according to at least claim 12, wherein the electrical resistance of a glass layer made of an alkali titanium silicate glass is greater than 1 GΩ.

15. Use of an alkali titanium silicate glass for making a housing (100) for accommodating an electronic functional element (40), in particular an LED and/or a FET, wherein components of the housing (100) are joined by the alkali titanium silicate glass which is **characterised in that** the alkali titanium silicate glass has the following composition (in wt%):
| | |
|---|---|
| SiO₂ | 20-50 |
| TiO₂ | 10-35 |
| R₂O | 10-40 |
| | |
| Al₂O₃ | 0-5 |
| | |
| CaO + SrO | 0-5 |
| P₂O₅ | 0-5 |
| V₂O₅ | 0-5 |
| B₂O₃ | 0-5 |
| | |
| Sb₂O₃ | 0-1 |
| SnO₂ | 0-5 |
| Fe₂O₃ | < 1 |
| CoO | < 1 |
| NiO | < 1 |
| | |
| ZnO | 0-4 |
| ZrO₂ | 0-4 |
| F | 0-2 |
| M0O₃ | 0-1 |
| N₂O₅ | 0-6 |
| | |
| SO₃ | 0-1 . |

## Revendications

1. Boîtier (100) destiné à accueillir un élément fonctionnel (40) électronique, qui est réalisé en utilisant un verre silicaté titano-alcalin et dans lequel des composants du boîtier (100) sont reliés par le verre silicaté titano-alcalin,
qui est **caractérisé par le fait que** le verre silicaté titano-alcalin présente la composition suivante (en % en poids) :
| | |
|---|---|
| SiO₂ | 20 à 50 |
| TiO₂ | 10 à 35 |
| R₂O | 10 à 40 |
| | |
| | |
| | |
| Al₂O₃ | 0 à 5 |
| | |
| | |
| CaO+SrO | 0 à 5 |
| P₂O₅ | 0 à 5 |
| V₂O₅ | 0 à 5 |
| B₂O₃ | 0 à 5 |
| | |
| Sb₂O₃ | 0 à 1 |
| SnO₂ | 0 à 5 |
| Fe₂O₃ | < 1 |
| CoO | < 1 |
| NiO | < 1 |
| ZnO | 0 à 4 |
| ZrO₂ | 0 à 4 |
| F | 0 à 2 |
| MoO₃ | 0 à 1 |
| N₂O₅ | 0 à 6 |
| | |
| SO₃ | 0 à 1 |

2. Boîtier (100) selon la revendication 1, comprenant un corps de base (10) et un corps de raccordement (30), le corps de base (10) et le corps de raccordement (30) comportant un métal.

3. Boîtier selon la revendication 2, dans lequel le corps de base (10) présente au moins un canal (11') dans lequel le corps de raccordement (30), au nombre d'au moins un, est disposé au moins en partie, et qui est rempli au moins par portions avec le verre silicaté titano-alcalin, aux fins de lier le corps de base au corps de raccordement.

4. Boîtier selon la revendication 2 ou 3, dans lequel le canal 11'), au nombre d'au moins un, débouche dans la face supérieure et/ou dans la face inférieure et/ou dans le bord du corps de base (10) et établit une liaison continue entre la face supérieure et/ou la face inférieure et/ou le bord du corps de base.

5. Boîtier selon l'une des revendications 2 à 4, dans lequel le canal (11') s'étend à partir d'une face avant du corps de base (10), en direction d'une face arrière, et est réalisé sous la forme d'un trou.

6. Boîtier (100) selon l'une des revendications 3 à 5, dans lequel le métal présente un coefficient de dilatation longitudinale thermique α qui est compris entre 13 et 25 ^{∗} 10⁻⁶ K⁻¹.

7. Boîtier (100) selon l'une des revendications 2 à 6, dans lequel le corps de base (10) et le corps de raccordement (30), en particulier dans les interfaces avec le verre (20), comportent du cuivre et/ou un alliage de cuivre et/ou de l'aluminium et/ou de l'acier austénitique et/ou de l'acier inoxydable austénitique.

8. Boîtier (100) selon l'une des revendications précédentes, dans lequel le verre silicaté titano-alcalin présente la composition suivante (en % en poids) :
| | |
|---|---|
| SiO₂ | 26 à 30 |
| TiO₂ | 21 à 25 |
| | |
| Na₂O | 14 à 18 |
| K₂O | 11 à 15 |
| Li₂O | > 0 à 3 |
| Al₂O₃ | > 1 à 5 |
| CaO | > 0 à 1 |
| SrO | 0 à 1 |
| | |
| P₂O₅ | > 0 à 3 |
| | |
| B₂O₃ | > 0 à 4 |
| | |
| | |
| | |
| Fe₂O₃ | > 0 à 2 |
| CoO | 0 à 1 |
| NiO | 0 à 1 |
| ZnO | > 0 à 2 |
| ZrO₂ | > 0,5 à 2 |
de préférence :
| | |
|---|---|
| SiO₂ | 28 |
| TiO₂ | 23 |
| | |
| Na₂O | 16 |
| K₂O | 13 |
| Li₂O | 1,12 |
| Al₂O₃ | 3,4 |
| CaO | 0,2 |
| SrO | 0,02 |
| | |
| P₂O₅ | 1,6 |
| | |
| B₂O₃ | 2 |
| | |
| | |
| | |
| Fe₂O₃ | 0,2 |
| CoO | 0,03 |
| NiO | <0,02 |
| ZnO | 0,2 |
| ZrO₂ | 0,9 |

9. Boîtier (100) selon l'une des revendications précédentes, dans lequel le verre silicaté titano-alcalin présente la composition suivante (en % en poids) :
| | |
|---|---|
| SiO₂ | 36 à 40 |
| TiO₂ | 24 à 28 |
| | |
| Na₂O | 15 à 19 |
| K₂O | 10 à 14 |
| Li₂O | > 0 à 3 |
| Al₂O₃ | 1 à 6 |
| CaO | > 0 à 1 |
| SrO | < 1 |
| | |
| P₂O₅ | > 0 à 4 |
| | |
| B₂O₃ | > 0 à 2 |
| | |
| | |
| | |
| Fe₂O₃ | 0 à 2 |
| CoO | < 1 |
| NiO | < 1 |
| ZnO | < 1 |
| ZrO₂ | < 1 |
de préférence :
| | |
|---|---|
| SiO₂ | 38 |
| TiO₂ | 26 |
| | |
| Na₂O | 17 |
| K₂O | 11,6 |
| Li₂O | 1,22 |
| Al₂O₃ | 3,7 |
| CaO | 0,3 |
| | |
| | |
| P₂O₅ | 1,6 |
| | |
| B₂O₃ | 0,29 |
| | |
| | |
| | |
| Fe₂O₃ | 0,08 |
| | |
| NiO | < 0,02 |
| ZrO₂ | 0,1 |

10. Boîtier (100) selon l'une des revendications précédentes 2 à 9, **caractérisé en ce que**
la couche de verre (20) est disposée au moins en partie entre l'enveloppe (13) du corps de base (10) et le corps de raccordement (30), et/ou
entre la face supérieure (10a) du corps de base (10) et le corps de raccordement (30)
entre la face inférieure (10b) du corps de base (10) et le corps de raccordement (30).

11. Boîtier (100) selon l'une des revendications 1 à 10, dans lequel le corps de raccordement (30) est isolé électriquement du corps de base (10) par une couche de verre.

12. Boîtier (100) selon l'une des revendications 2 à 11, dans lequel le corps de raccordement est une broche de contact (30'), et dans lequel la broche de contact (30') est notamment une broche sensiblement rectiligne ou est réalisée au moins par portions en forme de crochet ou en forme de L.

13. Boîtier (100) selon l'une des revendications précédentes, dans lequel le verre possède une température de ramollissement comprise dans une plage qui est inférieure à la température de fusion des matériaux utilisés pour le corps de base et/ou le corps de raccordement, et/ou boîtier (100) selon l'une des revendications précédentes, dans lequel le verre (20) présente une épaisseur qui est comprise dans une plage allant de 30 µm à 2 000 µm.

14. Boîtier selon au moins la revendication 12, dans lequel la résistance électrique d'une couche de verre formée avec le verre silicaté titano-alcalin est supérieure à 1 GΩ.

15. Utilisation d'un verre silicaté titano-alcalin pour la réalisation d'un boîtier (100) destiné à accueillir un élément fonctionnel (40) électronique, en particulier une LED et/ou un FET, des composants du boîtier (100) étant reliés par le verre silicaté titano-alcalin, qui est **caractérisé par le fait que** le verre silicaté titano-alcalin présente la composition suivante (en % en poids) :
| | |
|---|---|
| SiO₂ | 20 à 50 |
| TiO₂ | 10 à 3 5 |
| R₂O | 10 à 40 |
| | |
| | |
| | |
| Al₂O₃ | 0 à 5 |
| | |
| | |
| CaO+SrO | 0 à 5 |
| P₂O₅ | 0 à 5 |
| V₂O₅ | 0 à 5 |
| B₂O₃ | 0 à 5 |
| | |
| Sb₂O₃ | 0 à 1 |
| SnO₂ | 0 à 5 |
| Fe₂O₃ | < 1 |
| CoO | < 1 |
| NiO | < 1 |
| | |
| ZnO | 0 à 4 |
| ZrO₂ | 0 à 4 |
| F | 0 à 2 |
| MoO₃ | 0 à 1 |
| N₂O₅ | 0 à 6 |
| | |
| SO₃ | 0 à 1 |
